# FASCICULE DE BREVET EUROPEEN

(11) **EP 0 526 321 B1**
(45) Date de publication et mention de la délivrance du brevet: **14.08.1996**
(21) Numéro de dépôt: 92402161.1
(22) Date de dépôt: 27.07.1992
(51) Int. Cl.: G06F 11/18, H03K 19/23, G05B 9/03

(54) **Sélecteur de signaux à trois entrées, application à un sélecteur à n entrées ainsi qu'à un voteur à n entrées**
Drei-Eingänge-Signal Auswähler, angewendet auf einen N-Eingänge-Auswähler und eine N-Eingänge Abstimmungsschaltung
Three input signal selector, applied to an n input selector and an n input voter

(30) Priorité: 02.08.1991 FR 9109879
(43) Date de publication de la demande: 03.02.1993
(73) Titulaire: AEROSPATIALE Société Nationale Industrielle, F-75781 Paris Cédex 16 (FR)
(72) Inventeur: Bascans, Rémi, Résidence Les Cyclades - Bât E, F-31400 Toulouse (FR); Autechaud, Eric, F-31000 Toulouse (FR); Fleury, Christophe, F-31770 Colomiers (FR); N'Guyen, Christian, F-31700 Blagnac (FR)
(74) Mandataire: Bonnetat, Christian

(56) Documents cités:
- FR-A- 2 086 455
- ISA TRANSACTIONS, vol. 29, no. 2, 1 Février 1990, Pittsburgh, US, pp. 13-16; A.A. FREDERICKSON: 'Fault Tolerant Programmable Controllers for Safety Systems'

## Description

La présente invention concerne un sélecteur de signaux à trois entrées, son extension à n entrées et ses applications, notamment à la réalisation de voteurs.

On sait que les sélecteurs de signaux sont des dispositifs, matériels et/ou logiciels, qui, recevant une pluralité (généralement au moins égale à trois) de signaux d'entrée indépendants, issus de sous-systèmes utilisés en redondance, signaux représentatifs d'une même grandeur, délivrent un nombre inférieur de signaux de sortie, les signaux décelés comme étant incorrects n'apparaissant pas en sortie.

De même, un voteur assure une telle sélection et ne transmet qu'un seul signal, résultant d'un vote spécifique. Par exemple, dans le cas de trois signaux d'entrée :
- le vote est majoritaire et le signal de sortie est la valeur de deux signaux d'entrée identiques ; ou
- le vote concerne la médiane et le signal de sortie est constitué par le signal d'entrée qui est encadré par les deux autres ; ou
- le vote est adaptatif, le signal d'entrée le plus éloigné par rapport aux deux autres étant rejeté et le signal de sortie étant la moyenne des deux signaux d'entrée restants ; etc ...

Le rôle d'un voteur à trois entrées est d'assurer à sa sortie un signal correct à partir des trois signaux d'entrée, c'est-à-dire de tolérer la défaillance d'un de ses trois signaux d'entrée, ce qui pose, de par son principe, deux problèmes :
- lors de la défaillance, dans des états voisins, de deux signaux d'entrée, le vote privilégie les deux signaux d'entrée incorrects, car ils sont majoritaires, et ce fonctionnement non désiré n'est pas vu par le système. Les voteurs permettant de détecter l'existence d'une seconde entrée défaillante nécessitent un mécanisme supplémentaire qui rend l'ensemble plus complexe ;
- la sortie unique représente le point critique d'une architecture triplex (système composé de trois sous-systèmes remplissant la même fonction afin de fournir, à un voteur à trois entrées, trois signaux indépendants, mais représentatifs d'une même grandeur) car, lors d'une défaillance se manifestant en sortie du voteur, le service ne peut plus être rendu ou, pire, peut être incorrect. Autrement dit, un voteur n'est pas tolérant à ses propres défaillances, ce qui entraîne le risque de perdre un service correct sur une simple défaillance au niveau du voteur.

Suivant le type de voteur mis en oeuvre, on peut rencontrer d'autres difficultés :
- nécessité d'une synchronisation stricte des trois signaux d'entrée les uns par rapport aux autres pour effectuer le vote ;
- problème de traitement de signaux d'entrée corrects, mais non identiques, du fait des tolérances de chaque sous-système d'élaboration desdits signaux d'entrée ;
- problème du taux de détection de mauvais fonctionnement (proportion entre les défaillances détectées et non détectées) à partir de trois signaux, qui est plus complexe et moins déterministe que pour les architectures duplex (système composé de deux sous-systèmes remplissant la même fonction afin de fournir, à un mécanisme approprié, deux signaux indépendants, mais représentatifs d'une même grandeur) où la détection d'un mauvais fonctionnement du système est une simple comparaison de deux signaux ;
- problème de certains voteurs qui masquent les erreurs sans localiser l'entrée défaillante, d'où l'impossibilité d'informer le système quant à l'identité du sous-système défaillant.

Les voteurs logiciels permettent de mettre en place un vote évolué, mais au prix d'un temps de calcul non négligeable, qui peut être inexploitable pour les systèmes rapides. Aussi ce vote évolué implique un logiciel important qui demande un effort important de validation.

La présente invention a pour but de remédier à ces inconvénients. Elle permet, par la mise en oeuvre de moyens simples, à la fois d'augmenter la fiabilité opérationnelle et la sécurité. Elle concerne, de plus, tous les types de signaux, ceux-ci pouvant être électriques, optiques, pneumatiques, ou autres, analogiques ou numériques, séries ou parallèles. Elle est à même d'assurer à un système la continuité d'un service correct sur deux sorties indépendantes ou sur une seule sortie, suivant son application, lorsqu'un de ses sous-systèmes est défaillant et d'isoler la sortie du voteur lorsque celui-ci n'est plus en mesure d'assurer un service correct.

A cette fin, selon l'invention, le sélecteur de signaux comportant une première, une deuxième et une troisième entrée aptes à recevoir respectivement un premier, un deuxième et un troisième signal et comportant une première et une seconde sortie, est remarquable en ce qu'il comporte :
- un premier aiguilleur à deux voies, pourvu d'une entrée active, d'une entrée de repos, et d'une entrée de commande, apte à recevoir un signal de commande forçant, selon son état, ledit aiguilleur à un état actif ou à un état repos, et d'une sortie commune, ladite entrée de repos et ladite entrée active dudit premier aiguilleur étant respectivement reliées auxdites première et deuxième entrées dudit sélecteur, tandis que ladite sortie commune dudit premier aiguilleur est reliée à ladite première sortie du sélecteur, cette sortie commune transmettant le signal appliqué sur l'entrée active lorsque ledit premier aiguilleur est à l'état actif, et transmettant le signal appliqué sur l'entrée de repos lorsque ledit premier aiguilleur est à l'état repos ;
- un deuxième aiguilleur à deux voies, pourvu d'une entrée active, d'une entrée de repos, et d'une entrée de commande apte à recevoir un signal de commande forçant, selon son état, ledit aiguilleur à un état actif ou à un état repos, et d'une sortie commune, ladite entrée active et ladite entrée de repos dudit deuxième aiguilleur étant respectivement reliées auxdites deuxième et troisième entrées dudit sélecteur, tandis que ladite sortie commune dudit deuxième aiguilleur est reliée à ladite seconde sortie du sélecteur, cette sortie commune transmettant le signal appliqué sur l'entrée active lorsque ledit aiguilleur est à l'état actif, et transmettant le signal appliqué sur l'entrée de repos lorsque ledit aiguilleur est à l'état repos ;
- un premier moniteur à deux entrées respectivement reliées auxdites première et deuxième entrées dudit sélecteur de signaux, apte à mesurer l'écart entre lesdits premier et deuxième signaux, et dont la sortie est reliée à l'entrée de commande dudit deuxième aiguilleur et est susceptible de commander l'état de ce deuxième aiguilleur ; et
- un deuxième moniteur à deux entrées respectivement reliées auxdites deuxième et troisième entrées dudit sélecteur de signaux, apte à mesurer l'écart entre lesdits deuxième et troisième signaux et dont la sortie est reliée à l'entrée de commande dudit premier aiguilleur et est susceptible de commander l'état de ce premier aiguilleur.

Ainsi, ledit sélecteur configure automatiquement les trois signaux d'entrée en deux signaux de sortie. Ces deux signaux de sortie sont représentatifs l'un et l'autre du signal appliqué sur ladite deuxième entrée, lorsqu'aucun des signaux appliqués sur les trois entrées n'est défaillant, et ils sont surveillés par deux moniteurs indépendants. En cas de défaillance de l'un des trois signaux d'entrée, le signal d'entrée défaillant est isolé et les deux signaux de sortie sont représentatifs des deux autres signaux d'entrée, ce qui est favorable à la fiabilité opérationnelle. Ces deux sorties dudit sélecteur sont donc tolérantes à une défaillance, par le fait que les deux signaux de sortie sont indépendants d'un signal d'entrée. On peut contrôler ces deux signaux de sortie l'un par rapport à l'autre ou exploiter ces deux signaux de sortie au moyen de deux systèmes distincts, comme pour les architectures duplex, ce qui est favorable à la sécurité.

Les moniteurs et les aiguilleurs peuvent présenter toute structure appropriée.

Un mode de réalisation électrique, donné à titre d'exemple pour des signaux analogiques ou numériques, séries ou parallèles, est remarquable en ce que chacun desdits moniteurs comprend :
- des moyens différenciateurs pour mesurer la différence entre les signaux appliqués aux entrées dudit moniteur ;
- des moyens comparateurs, pour comparer ladite différence à un seuil prédéterminé, et engendrer un signal d'erreur si la valeur absolue de ladite différence est supérieure à la valeur absolue dudit seuil.

Ainsi, ledit moniteur délivre un signal de sortie destiné à commander dans un état donné l'aiguilleur à deux voies associé, non seulement lorsque les deux signaux appliqués à ses entrées sont identiques, mais encore lorsque ces derniers signaux sont légèrement différents (du fait d'un décalage en amplitude et/ou en phase), ledit seuil permettant de tolérer des différences acceptables en amplitude, tandis qu'une différence trop grande entre les signaux d'entrée entraîne un signal d'erreur (ce qui veut dire le changement d'état du signal de sortie) qui sert à faire changer d'état un aiguilleur de façon à supprimer la transmission du signal incorrect.

Avantageusement, afin de masquer l'effet de défauts transitoires, des moyens temporisateurs sont interposés en série sur la sortie du moniteur.

Chaque aiguilleur à deux voies peut être du type commutateur électrique ou dispositif de commutation électrique, et constitué d'un ou plusieurs éléments de commutation identiques disposés en parallèle.

Dans le cas où les signaux d'entrée sont optiques, chaque aiguilleur à deux voies peut être du type multiplexeur optique à commande électrique, ou dispositif de commutation optique à commande électrique constitué de plusieurs éléments de commutation optique à commande électrique identiques disposés en parallèle.

Si les signaux d'entrée sont pneumatiques ou hydrauliques, chaque aiguilleur à deux voies est avantageusement du type commutateur hydraulique ou pneumatique ou commutateur hydraulique ou pneumatique constitué de plusieurs éléments de commutation identiques disposés en parallèle. Chacun des moniteurs peut comporter un organe soumis à l'action antagoniste des signaux apparaissant aux entrées de signal dudit moniteur et commandant le passage de fluide entre une source de pression et la sortie dudit moniteur. De même, chacun desdits aiguilleurs peut comporter un organe soumis à l'action du signal appliqué à l'entrée de commande dudit aiguilleur, ledit organe étant apte à mettre en communication l'un ou l'autre de deux orifices d'entrée de signal avec un orifice de sortie.

Selon une variante, ledit sélecteur de signaux est remarquable en ce que :
- le premier aiguilleur et le deuxième aiguilleur comportent respectivement, de plus, une sortie d'état fournissant un signal représentatif de l'état actif ou repos dudit aiguilleur ;
   et en ce qu'il comporte :
- un moyen détecteur à deux entrées reliées respectivement à la sortie d'état du premier aiguilleur et deuxième aiguilleur, apte à fournir, sur sa sortie, une information significative de la présence à l'état repos de l'un au moins des premier aiguilleur et deuxième aiguilleur ;
- un premier moyen de verrouillage, interposé entre la sortie dudit premier moniteur et l'entrée de commande dudit deuxième aiguilleur, recevant, sur une entrée de commande, ladite information issue de la sortie du moyen détecteur et permettant audit premier moniteur de commander l'état dudit deuxième aiguilleur si ledit moyen détecteur n'a pas préalablement détecté qu'au moins un desdits premier et deuxième aiguilleur est dans son état repos, et, dans l'autre cas, empêchant ledit premier moniteur de commander ledit deuxième aiguilleur ;
- un second moyen de verrouillage, interposé entre la sortie dudit second moniteur et l'entrée de commande dudit premier aiguilleur, recevant, sur une entrée de commande, ladite information issue de la sortie du moyen détecteur et permettant audit deuxième moniteur de commander l'état dudit premier aiguilleur si ledit moyen détecteur n'a pas préalablement détecté qu'au moins un desdits premier et deuxième aiguilleur est dans son état repos, et, dans l'autre cas, empêchant ledit deuxième moniteur de commander ledit premier aiguilleur.

On voit que le sélecteur de signaux conforme à la présente invention constitue en lui-même un sélecteur à trois entrées et à deux sorties. Il peut donc servir d'étage intermédiaire entre un système triplex et un système duplex. De plus, les deux signaux de sortie du sélecteur peuvent être traités de toute manière connue, par exemple à l'aide d'une logique de commutation, afin d'obtenir un seul signal de sortie, ou encore à l'aide d'un second étage qui compare les deux signaux de sortie pour détecter une deuxième défaillance afin d'isoler la (ou les) sortie(s) du sélecteur. Il est encore possible de compléter le sélecteur par une logique de maintien avec blocage, comme expliqué ci-dessus, qui le bloque dans son état commuté après détection d'une première erreur dans les signaux d'entrée afin d'éviter qu'une deuxième erreur, intervenant par la suite, pour laquelle les deux signaux incorrects seraient identiques, n'amène le sélecteur à réagir aux deux signaux défaillants comme s'il s'agissait de signaux corrects, c'est-à-dire les sélectionner au détriment de celui qui est correct. En d'autres termes, le sélecteur de signaux conforme à la présente invention peut faire l'objet de nombreuses applications, avec ou sans l'adjonction d'éléments additionnels.

Selon une application dudit sélecteur de signaux à trois entrées, on réalise un sélecteur de signaux ayant une pluralité de n entrées (avec n entier ≥3) et deux sorties, comportant une pluralité de n-2 sélecteurs de signaux à trois entrées, qui est remarquable en ce que lesdits sélecteurs de signaux à trois entrées sont respectivement montés en cascade, les trois entrées du premier sélecteur de signaux à trois entrées étant respectivement reliées à trois desdites n entrées, alors que, pour chacun des n-3 autres sélecteurs de signaux à trois entrées de rang i (avec 1<i≤n-2), deux de ses entrées sont reliées respectivement aux sorties du sélecteur de signaux à trois entrées amont de rang i-1, la troisième desdites entrées du sélecteur de signaux à trois entrées de rang i étant reliée en propre à l'une desdites n entrées dudit sélecteur de signaux à n entrées, tandis que les sorties du sélecteur de signaux le plus en aval sont respectivement reliées aux sorties dudit sélecteur de signaux à n entrées.

Ainsi, ledit ou lesdits n-2 sélecteur(s) de signaux constitué(s) desdits premier et deuxième aiguilleurs à deux voies et desdits premier et deuxième moniteurs, forme(nt) un sélecteur à n entrées qui configure automatiquement les n signaux d'entrée en deux signaux de sortie, isolant les éventuels signaux d'entrée défaillants. Cela permet de tolérer la défaillance de n-2 signaux d'entrée, et assure ainsi, par le choix d'un nombre n d'entrées suffisant, une bonne fiabilité pour la fourniture de signaux corrects en sortie.

Ledit sélecteur de signaux à n entrées peut servir à constituer un voteur à n entrées et une sortie, comportant ledit sélecteur de signaux à n entrées, qui est remarquable en ce qu'il comporte :
- un premier interrupteur, pourvu d'une entrée active et d'une entrée de commande apte à mettre, ou non, ladite entrée active en relation avec une sortie commune selon que ce premier interrupteur est respectivement à l'état actif ou à l'état repos, en fonction du signal appliqué sur ladite entrée de commande, ladite entrée active et ladite sortie commune dudit premier interrupteur étant respectivement reliées à l'une desdites sorties dudit sélecteur de signaux à n entrées et à la sortie dudit voteur à n entrées ; et
- un premier moniteur de sortie, à deux entrées, qui sont respectivement reliées auxdites sorties dudit sélecteur de signaux à n entrées et sont aptes à mesurer l'écart entre les signaux apparaissant sur lesdites sorties du sélecteur de signaux à n entrées, et dont la sortie est reliée à l'entrée de commande dudit premier interrupteur et est susceptible de commander l'état dudit premier interrupteur.

Ainsi, ledit sélecteur de signaux à n entrées forme un premier étage qui configure automatiquement les n signaux d'entrée en deux signaux intermédiaires, isolant les éventuels signaux d'entrée défaillants, tandis que ledit premier moniteur de sortie et ledit premier interrupteur forment un second étage qui compare ces deux signaux intermédiaires engendrés par le premier étage pour détecter une défaillance à ce niveau, afin d'isoler la sortie du voteur s'il y a désaccord entre lesdits signaux intermédiaires. On augmente ainsi la sécurité. En amont du premier étage du voteur se trouve une structure au moins triplex de sous-systèmes en redondance permettant d'augmenter la fiabilité opérationnelle de l'ensemble, alors qu'en aval de ce premier étage est disposé un second étage permettant de contrôler la cohérence des deux signaux de sortie du premier étage.

Les mécanismes mis en oeuvre sont du même type que ceux utilisés pour les structures duplex (les plus simples à réaliser), ce qui permet d'obtenir une bonne détection de mauvais fonctionnement du système et de manière tout aussi déterministe que les architectures duplex (simple comparaison de deux grandeurs indépendantes dont le résultat est "oui" ou "non"). Ces mécanismes sont totalement indépendants les uns des autres (pas de point commun), de sorte que la défaillance de l'un d'eux ne peut provoquer la défaillance des autres, ce qui permet de tolérer la défaillance au niveau du premier étage de l'un d'eux (le service est toujours assuré) tout en respectant le critère de sécurité car l'invention assure dans tous les cas de figure une double surveillance.

De plus, l'invention permet d'obtenir une meilleure sécurité que les systèmes duplex (dont l'objectif est la sécurité), car dans le cas le plus défavorable pour une structure duplex, il y a risque d'engendrer une sortie incorrecte lors de deux défaillances, alors que pour ledit voteur associé à une structure triplex, toujours dans le cas le plus défavorable, il faut trois défaillances pour engendrer une sortie incorrecte (la première défaillance est tolérée par le premier étage, ce qui ramène à une structure duplex et, comme précédemment, il faut alors deux autres défaillances pour qu'il y ait risque d'une sortie incorrecte). De plus, avec ledit voteur en mode dégradé (structure duplex), on a toujours le même taux de détection de mauvais fonctionnement, ce qui permet d'assurer le même niveau de sécurité que les structures duplex.

Le principe de fonctionnement de l'invention est simple et s'adapte à tous les types de signaux, optiques, électriques ou autres. Toutefois la réalisation du voteur, en particulier des moniteurs, dépend :
- du type des signaux d'entrée ;
- des contraintes liées aux interactions avec l'environnement (fonctionnement asynchrone, mécanisme de détection des défaillances, temps de réponse garantie souhaité, etc ...).

Selon l'application, il en résulte donc une quantité de réalisations dont seulement quelques unes sont décrites dans la présente description.

De plus, le système selon l'invention a la possibilité de connaître l'identité du sous-système défaillant en analysant la configuration du voteur, et ainsi le système peut diagnostiquer (en terme de nature et de localisation) sa défaillance afin d'agir en conséquence.

De façon à encore améliorer la fiabilité dudit voteur, il peut comporter :
- m interrupteurs, lesdites entrée active et sortie commune de chacun desdits m interrupteurs étant respectivement reliées à l'une desdites sorties dudit sélecteur de signaux à n entrées et à la sortie dudit voteur à n entrées ; et
- m moniteurs de sortie, à deux entrées, dont l'une des deux entrées est reliée à l'une des sorties dudit sélecteur de signaux à n entrées et dont l'autre des deux entrées est reliée à l'autre des sorties dudit sélecteur de signaux à n entrées, aptes à mesurer l'écart entre les signaux apparaissant sur lesdites sorties dudit sélecteur de signaux à n entrées, et dont la sortie est reliée en propre à l'entrée de commande de l'un desdits m interrupteurs, de même rang j, et est susceptible de commander l'état dudit interrupteur.

Ainsi, ledit second étage peut comporter plusieurs ensembles interrupteur-moniteur de sortie en parallèle, constituant une structure redondante permettant de masquer des passages à l'état repos d'interrupteurs, dus à des défaillances.

Bien entendu, lesdits moniteurs de sortie peuvent être semblables auxdits premier et deuxième moniteurs, tandis que les interrupteurs peuvent être d'un type simplifié de celui des aiguilleurs puisqu'ils n'ont pas d'entrée de repos.

Les figures du dessin annexé feront bien comprendre comment l'invention peut être réalisée. Sur ces figures, des références identiques désignent des éléments semblables.

La figure 1 donne le schéma synoptique du sélecteur de signaux à trois entrées conforme à la présente invention.

La figure 2 est la table de vérité du sélecteur de signaux à trois entrées de la figure 1.

La figure 3 donne le schéma synoptique d'un exemple de réalisation d'un moniteur utilisé dans ledit sélecteur, avec un seuil.

La figure 4 montre le schéma synoptique d'une variante, comportant en plus un temporisateur, du moniteur représenté sur la figure 3.

La figure 5 illustre un mode de réalisation dudit moniteur avec temporisateur, sous forme électronique.

Les figures 6a à 6f sont des chronogrammes de signaux permettant d'expliquer le fonctionnement du moniteur de la figure 5.

La figure 7 donne le schéma synoptique d'un exemple de réalisation d'un aiguilleur à plusieurs voies parallèles.

La figure 8 représente schématiquement un sélecteur de signaux à trois entrées, ayant un fonctionnement avec blocage mémorisant la configuration après un premier défaut.

La figure 9 est un graphe de transitions illustrant le fonctionnement du sélecteur avec blocage montré sur la figure 8.

La figure 10 montre schématiquement un sélecteur de signaux à n entrées réalisé par une cascade de sélecteurs de signaux à trois entrées conformes à l'invention.

La figure 11 illustre schématiquement l'application d'un sélecteur à n entrées à la réalisation d'un voteur à n entrées.

La figure 12 montre un tel voteur à trois entrées.

La figure 13 est une table de vérité du voteur montré sur la figure 12.

La figure 14 illustre un voteur redondant en sortie.

La figure 15 illustre un voteur à trois entrées, comme illustré sur la figure 14, avec une redondance d'ordre 2 en sortie.

La figure 16 illustre la réalisation en technique électro-optique du voteur de la figure 11.

La figure 17 illustre la réalisation en technique hydraulique ou pneumatique du voteur de la figure 11.

Les figures 18 et 19 montrent schématiquement la réalisation pneumatique ou hydraulique d'un moniteur et d'un aiguilleur à deux voies selon l'invention, respectivement.

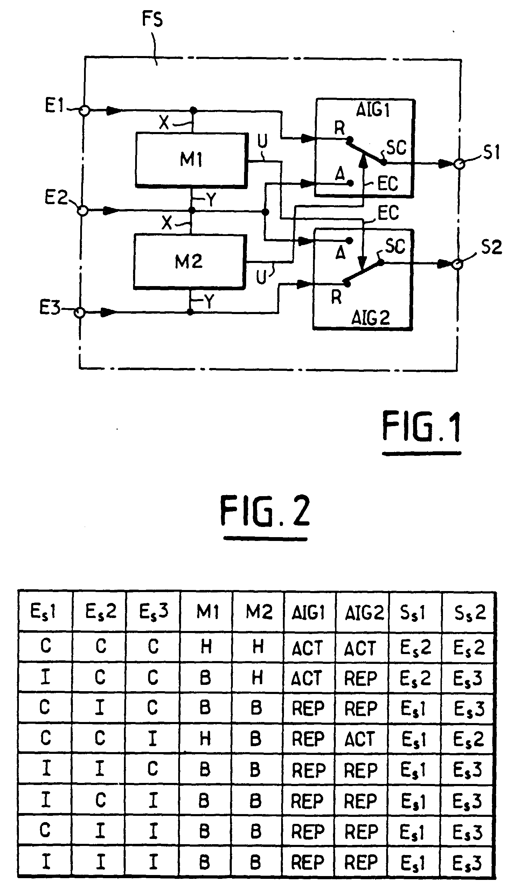

Le sélecteur FS de signaux, conforme à la présente invention et montré par la figure 1, est pourvu d'une première entrée E1, d'une deuxième entrée E2 et d'une troisième entrée E3, ainsi que d'une première sortie S1 et d'une seconde sortie S2. Il comporte :
- un premier aiguilleur AIG1 à deux voies, pourvu d'une entrée active A, d'une entrée de repos R et d'une entrée de commande EC, premier aiguilleur qui transmet, à une sortie commune SC, le signal appliqué sur l'entrée active A ou sur l'entrée de repos R selon que ce premier aiguilleur AIG1 est respectivement à l'état actif ACT ou à l'état repos REP, en fonction du signal reçu sur ladite entrée de commande EC. Ladite entrée de repos R et ladite entrée active A dudit premier aiguilleur AIG1 sont respectivement reliées à la première entrée El et à la deuxième entrée E2 du sélecteur FS de signaux, tandis que ladite sortie commune SC est reliée à la première sortie S1 de ce sélecteur FS de signaux ;
- un deuxième aiguilleur AIG2 à deux voies, de même constitution que le premier aiguilleur AIG1, l'entrée active A et l'entrée de repos R dudit deuxième aiguilleur AIG2 étant respectivement reliées à la deuxième entrée E2 et à la troisième entrée E3 du sélecteur FS de signaux, tandis que sa sortie commune SC est reliée à la seconde sortie S2 de ce sélecteur FS de signaux ;
- un premier moniteur M1 à deux entrées X, Y, respectivement reliées auxdites première et deuxième entrées E1 et E2 et dont la sortie U est reliée à l'entrée de commande EC du deuxième aiguilleur AIG2 et est susceptible de commander l'état dudit deuxième aiguilleur AIG2 ; et
- un deuxième moniteur M2 à deux entrées X, Y, respectivement reliées auxdites deuxième et troisième entrées E2 et E3, et dont la sortie U est reliée à l'entrée de commande EC du premier aiguilleur AIG1 et est susceptible de commander l'état dudit premier aiguilleur AIG1;

l'état des sorties U desdits moniteurs M1 et M2 et l'état desdits aiguilleurs AIG1 et AIG2 étant, lorsque l'un desdits premier, deuxième ou troisième signaux (Eₛ1, Eₛ2, Eₛ3) est incorrect représentatifs de l'identité de l'entrée (E1, E2, E3) transmettant un signal incorrect.

Le signal Uₛ en sortie de chacun des deux moniteurs M1 et M2 peut prendre un parmi deux états possibles, selon que ce moniteur M1 ou M2 a détecté ou pas une discordance entre les signaux d'entrée Xₛ et Yₛ appliqués respectivement sur ses deux entrées X et Y. Ces deux états possibles peuvent apparaître sous forme de toutes grandeurs, en fonction de la réalisation de ces moniteurs M1 et M2, par exemple un signal électrique de niveau constant haut ou bas, ou une valeur de commande numérique, ou encore la présence ou l'absence d'une pression ou toute autre grandeur. Dans un but de clarté, on appelle état bas B l'un de ces états, et état haut H l'autre état en sortie U des moniteurs M1 et M2. Comme expliqué ci-dessus, une telle appellation ne préjuge pas de la façon dont ces états sont traduits physiquement, et en particulier pas de la grandeur relative entre les deux signaux traduisant ces états. La sortie U est à l'état bas B lorsque les deux signaux Xₛ et Yₛ reçus sur lesdites entrées X et Y sont différents, et est à l'état haut H lorsque le moniteur M1 ou M2 reçoit des signaux Xₛ et Yₛ identiques sur ses deux entrées X et Y. Dans la présente description, on considère comme "différents" des signaux Xₛ et Yₛ dont l'écart est hors d'un domaine de tolérance accepté et comme "identiques" des signaux Xₛ et Yₛ dont l'écart est dans ledit domaine de tolérance. Il est à noter que le domaine de tolérance peut être nul et, dans ce cas, le contrôle est la vérification d'une stricte égalité.

Un moniteur M1 ou M2 commande respectivement l'aiguilleur AIG2 ou AIG1 qu'il contrôle, à l'état actif ACT, lorsqu'il lui fournit un état haut H, et à l'état repos R, lorsqu'il lui fournit un état bas B, sur l'entrée de commande EC.

En l'absence d'une source de puissance alimentant le sélecteur FS, les aiguilleurs AIG1 et AIG2 sont à l'état repos REP.

Le fonctionnement du sélecteur FS de la figure 1 est décrit ci-après, en regard de la table de vérité de la figure 2 : la sortie U du moniteur M1 ou M2 est à l'état bas B lorsque les deux signaux Xₛ et Yₛ sur ses entrées X et Y sont différents, et à l'état haut H lorsque ces deux signaux sont identiques. Dans cette table de vérité, on a désigné par Eₛ1, Eₛ2 et Eₛ3 chacun des trois signaux d'entrée appliqués respectivement aux entrées E1, E2 et E3. De même, on désigne par Sₛ1 et Sₛ2 les signaux de sortie apparaissant respectivement aux sorties S1 et S2 dudit sélecteur FS de signaux. On peut avoir les configurations suivantes :
1) le sélecteur FS n'est pas alimenté par une source de puissance. Alors, les aiguilleurs AIG1 et AIG2 sont dans l'état repos REP, cette situation étant celle représentée sur la figure 1 ;
2) les trois signaux Eₛ1, Eₛ2 et Eₛ3 sont corrects, ce qui est indiqué par la lettre C de la table de vérité de la figure 2. Alors, les moniteurs M1 et M2 détectent respectivement l'identité des signaux Eₛ1 et Eₛ2 et celle des signaux Eₛ2 et Eₛ3 et leurs sorties U sont à l'état haut H et commandent les aiguilleurs AIG1 et AIG2 à l'état actif ACT. Il en résulte que, sur les sorties communes SC des aiguilleurs AIG1 et AIG2, apparaissent respectivement des signaux de sortie Sₛ1 et Sₛ2 identiques entre eux et égaux au signal Eₛ2 ;
3) le signal Eₛ1 est incorrect, ce qui est indiqué par la lettre I dans le tableau de la figure 2, alors que les signaux Eₛ2 et Eₛ3 sont corrects. Le moniteur M1, constatant la différence des signaux Eₛ1 et Eₛ2, a un état bas B en sortie qui oblige l'aiguilleur AIG2 à avoir l'état repos REP, de sorte que le signal Sₛ2 est égal au signal Eₛ3. Par ailleurs, le moniteur M2, constatant l'identité des signaux Eₛ2 et Eₛ3, est à l'état haut H en sortie et commande l'aiguilleur AIG1 à son état actif ACT. Le signal Sₛ1 est donc égal au signal Eₛ2 ;
4) si maintenant les signaux Eₛ1 et Eₛ3 sont corrects, mais que le signal Eₛ2 est incorrect, les sorties U des moniteurs M1 et M2 sont alors à l'état bas B et les aiguilleurs AIG1 et AIG2 sont à l'état repos REP ; les signaux Sₛ1 et Sₛ2 sont alors égaux respectivement aux signaux Eₛ1 et Eₛ3 ;
5) de même, si les signaux Eₛ1 et Eₛ2 sont corrects, mais que le signal Eₛ3 est incorrect, les sorties U des moniteurs M1 et M2 sont respectivement à l'état haut H et à l'état bas B et les aiguilleurs AIG1 et AIG2 sont respectivement à l'état repos REP et à l'état actif ACT, de sorte que les signaux Sₛ1 et Sₛ2 sont respectivement égaux aux signaux Eₛ1 et Eₛ2 ;
6) si deux des signaux Eₛ1, Eₛ2, Eₛ3 sont incorrects et différents, un seul d'entre eux étant correct, les sorties U des moniteurs M1 et M2 sont à l'état bas B et les aiguilleurs AIG1 et AIG2 sont à l'état repos REP, de sorte que les signaux Sₛ1 et Sₛ2 sont respectivement égaux aux signaux différents Eₛ1 et Eₛ3 ; le cas particulier où les deux signaux incorrects sont identiques est traité plus loin ;
7) enfin, si les trois signaux Eₛ1, Eₛ2, Eₛ3 sont incorrects, les signaux Sₛ1 et Sₛ2 sont respectivement égaux aux signaux incorrects, différents dans le cas général, Eₛ1 et Eₛ3.

On remarquera que lorsque l'un des trois signaux Eₛ1, Eₛ2 ou Eₛ3 est incorrect (lignes 2, 3 et 4 de la figure 2), l'état des sorties U des moniteurs M1 et M2 et l'état des aiguilleurs AIG1 et AIG2 est représentatif de l'identité de l'entrée transmettant un signal incorrect. En effet :
1) si les sorties U des moniteurs M1 et M2 sont respectivement à l'état bas B et à l'état haut H, ou bien si les aiguilleurs AIG1 et AIG2 sont respectivement à l'état actif ACT et repos REP, c'est le signal Eₛ1 qui est incorrect ;
2) si les sorties U des moniteurs M1 et M2 sont toutes deux à l'état bas B, ou bien si les aiguilleurs AIG1 et AIG2 sont tous deux à l'état repos REP, c'est le signal Eₛ2 qui est incorrect ;
3) enfin, si les sorties U des moniteurs M1 et M2 sont respectivement à l'état haut H et à l'état bas B, ou bien si les aiguilleurs AIG1 et AIG2 sont respectivement à l'état repos REP ou actif ACT, c'est le signal Eₛ3 qui est incorrect.

Ainsi, il est possible, en surveillant l'état des moniteurs M1 et M2 et/ou l'état des aiguilleurs AIG1 et AIG2, de connaître l'identité du signal d'entrée Eₛ1, Eₛ2, Eₛ3 incorrect et donc d'identifier le sous-système dont la sortie, reliée à l'une des entrées E1, E2, E3 du sélecteur FS de signaux, est incorrecte.

Par ailleurs, on remarquera que le sélecteur FS de signaux, formé par les couples moniteur-aiguilleur M1, AIG2 et M2, AIG1 est tolérant à sa propre défaillance (celle d'un des deux couples) au sens où on conserve sur chaque sortie S1, S2 un des signaux Eₛ1, Eₛ2, Eₛ3. En effet, si un moniteur M1, M2 ou un aiguilleur AIG1, AIG2 est le siège d'une panne, les aiguilleurs étant, soit dans l'état actif ACT, soit dans l'état repos REP, la continuité électrique assure toujours la présence, sur chacune des sorties S1 et S2, de l'un des trois signaux d'entrée Eₛ1, Eₛ2, Eₛ3.

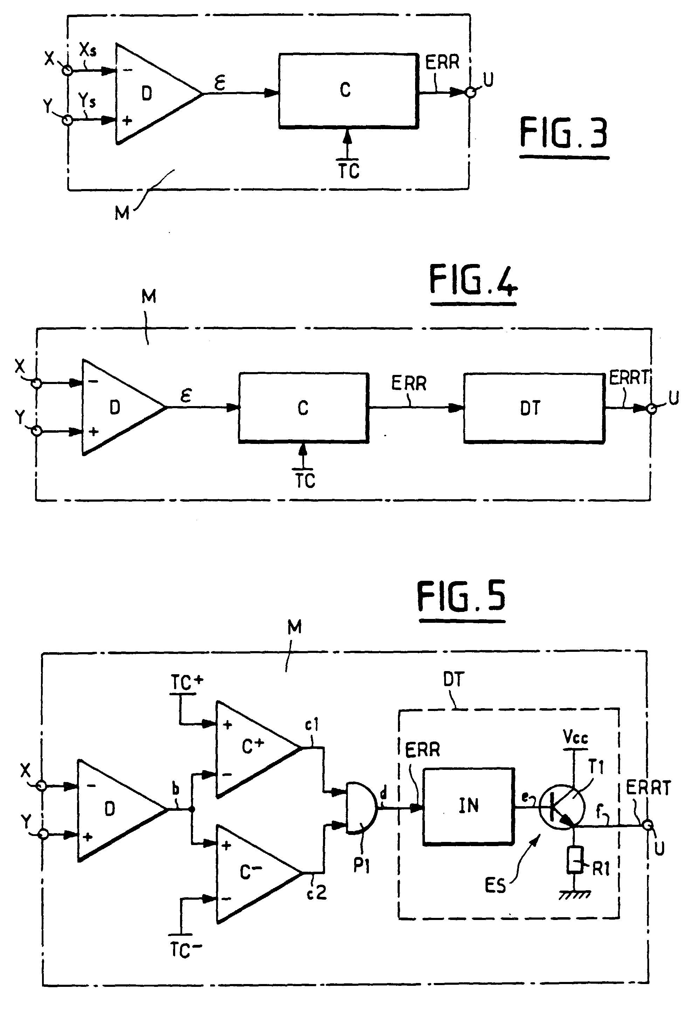

Les moniteurs M peuvent, de plus, comporter, en sortie, un comparateur à seuil. La figure 3 montre le schéma de principe d'un tel moniteur M, apte à traiter des signaux analogiques ou numériques. Un moyen différenciateur D reçoit respectivement, sur les deux entrées X et Y, deux signaux Xₛ et Yₛ à comparer, et fournit, en sortie, un signal ε proportionnel à la différence de ces deux signaux. Ce signal ε est appliqué à une première entrée d'un comparateur à seuil C, recevant, sur une deuxième entrée, une valeur de seuil prédéterminée (TC), et fournissant, en sortie U, un signal ERR significatif du fait que le signal ε est d'amplitude supérieure au seuil.

La comparaison des signaux Xₛ et Yₛ appliqués sur les entrées X et Y des moniteurs M est réalisée par des circuits analogiques et/ou numériques ou en logiciel, selon les applications désirées.

La sortie du comparateur à seuil C peut, de plus, être reliée à l'entrée d'un temporisateur DT, tel que représenté sur la figure 4, dont la sortie U fournit un signal d'erreur temporisé ERRT après que la sortie du comparateur C ait été au niveau bas, significatif d'une discordance entre les signaux d'entrée Xₛ et Yₛ, pendant au moins une durée Tₛ prédéterminée.

Comme on l'a mentionné ci-dessus, le sélecteur FS peut être utilisé pour des signaux d'entrée Eₛ1, Eₛ2 et Eₛ3 de différents types. Sur la figure 5, on a représenté un mode de réalisation des moniteurs M1 et M2 approprié à des signaux électriques analogiques, avec un comparateur à seuil C.

Le moniteur M de la figure 5 comporte :
- un amplificateur différentiel D, jouant le rôle de moyen différenciateur D, dont les entrées sont respectivement reliées aux entrées X et Y dudit moniteur ;
- un premier comparateur C⁺, dont l'entrée positive reçoit une tension représentative d'un seuil positif TC⁺ et dont l'entrée négative est reliée à la sortie dudit amplificateur différentiel D ;
- un second comparateur C⁻, dont l'entrée positive est reliée à la sortie dudit amplificateur différentiel D et dont l'entrée négative reçoit une tension représentative d'un seuil négatif TC⁻ ;
- une porte logique P1, de type ET, dont les entrées sont respectivement reliées aux sorties desdits premier et second comparateurs C⁺ et C⁻ ;
- un intégrateur IN, dont l'entrée est reliée à la sortie de la porte P1 ; et
- un étage de sortie ES, comportant un transistor interrupteur T1 dont la base est reliée à la sortie de l'intégrateur IN, le collecteur à une tension d'alimentation Vcc et l'émetteur à la masse par l'intermédiaire d'une résistance R1 (le montage du transistor T1 représenté n'est donné qu'à titre d'illustration du fonctionnement de celui-ci et ne correspond pas obligatoirement au montage réel mis en oeuvre).

La sortie U du moniteur M est reliée à l'émetteur du transistor T1, de manière qu'en cas de coupure d'alimentation ou de destruction du transistor T1 en circuit ouvert, la sortie U du moniteur M soit à une tension voisine de celle de la masse, tension pouvant correspondre à l'état bas B, et ainsi que l'aiguilleur associé soit à l'état repos REP.

Le premier comparateur C⁺ délivre un signal d'amplitude constante (état haut) à sa sortie, lorsque le signal qu'il reçoit de l'amplificateur différentiel D est inférieur au seuil positif TC⁺, et, de façon symétrique, le second comparateur C⁻ délivre un signal d'amplitude constante (état haut) à sa sortie, lorsque le signal qu'il reçoit de l'amplificateur différentiel D est supérieur au seuil négatif TC⁻, si bien que ces deux comparateurs C⁺ et C⁻ fournissent simultanément un état haut en sortie si le signal issu de l'amplificateur différentiel D est compris entre le seuil positif TC⁺ et le seuil négatif TC⁻, si bien que la porte logique P1 fournit en sortie, dans ce cas seulement, un état haut.

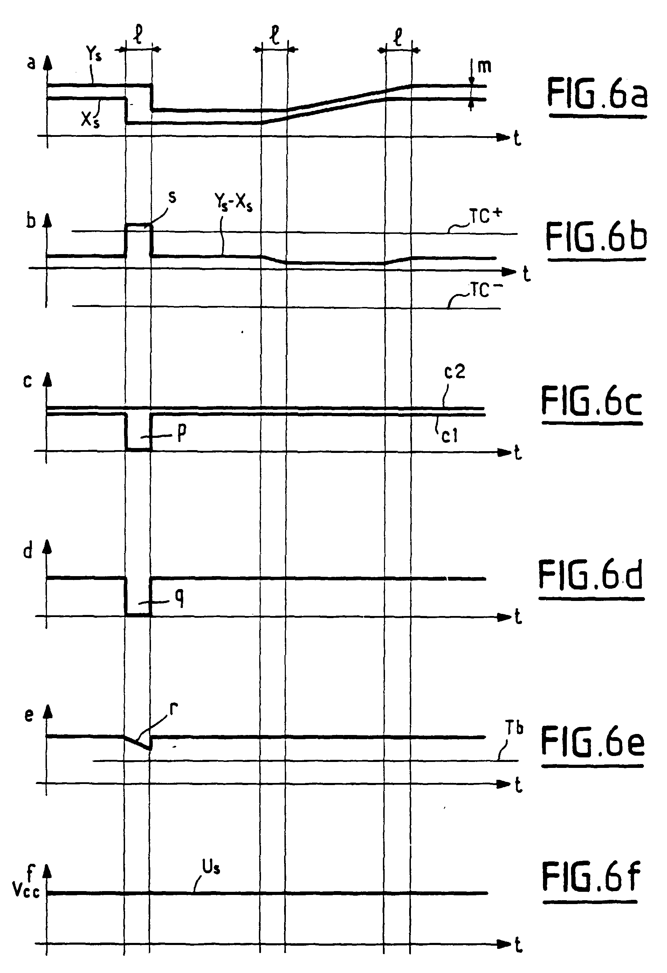

Pour illustrer le fonctionnement du moniteur M de la figure 5, on fait appel ci-après aux diagrammes des figures 6a à 6f, sur l'axe des abscisses desquels on a porté le temps t.

Le chronogramme de la figure 6a donne un exemple de signaux Xₛ et Yₛ, dont l'amplitude a est portée sur l'axe des ordonnées. On peut voir que les signaux Xₛ et Yₛ sont semblables, mais qu'ils sont déphasés de l et décalés en amplitude de m. Le chronogramme de la figure 6b représente le signal Yₛ-Xₛ, à la sortie de l'amplificateur différentiel D, l'amplitude b du signal Yₛ-Xₛ étant portée sur l'axe des ordonnées. On peut voir que, pour sa plus grande part, l'amplitude b du signal Yₛ-Xₛ est comprise entre les seuils TC⁺ et TC⁻ des comparateurs C⁺ et C⁻, sauf en ce qui concerne la portion s, qui dépasse le seuil positif TC⁺. Il en résulte que, à leurs sorties respectives, le comparateur C⁺ délivre un signal d'amplitude haute constante c1, sauf en regard de la portion s où le niveau haut du signal c1 est interrompu (en p) et le comparateur C⁻ délivre également un signal d'amplitude haute constante c2 (figure 6c). Par suite, le signal d à la sortie de la porte P1 est constant et au niveau haut, sauf en regard de l'interruption p, où il présente une interruption q (figure 6d). A la sortie de l'intégrateur IN, le signal e est donc constant et au niveau haut, sauf en regard de l'interruption q, où il présente une rampe r correspondant à la décharge lente dudit intégrateur IN. Si, comme cela est illustré sur la figure 6e, le signal e et sa rampe r sont supérieurs au seuil de blocage Tb du transistor T1, celui-ci est conducteur et la tension d'alimentation Vcc se retrouve en grande partie sur la sortie U du moniteur M (voir la figure 6f sur laquelle l'amplitude f du signal Uₛ est portée sur l'axe des ordonnées).

Le chronogramme de la figure 6f correspond à l'état haut H, pris comme étant une tension voisine de Vcc, de la sortie U du moniteur M.

On comprendra ainsi que, si l'amplitude b du signal Yₛ-Xₛ sort du couloir TC⁺, TC⁻ (voir la figure 6b) pendant un temps suffisamment long, la rampe r du signal e passe au-dessous du seuil de blocage Tb du transistor T1 (figure 6e), de sorte que la conduction de celui-ci est bloquée et que le signal f devient nul. La sortie U du moniteur M est alors dans son état bas B.

Les tolérances sur les paramètres de détection (TC⁺, TC⁻, Tₛ) doivent être suffisamment "larges" pour éviter des déconnexions intempestives, mais doivent cependant être suffisamment "étroites" pour qu'un signal erroné en sortie pendant la durée T_{S} ne soit pas gênant pour le système utilisant ledit sélecteur FS de signaux.

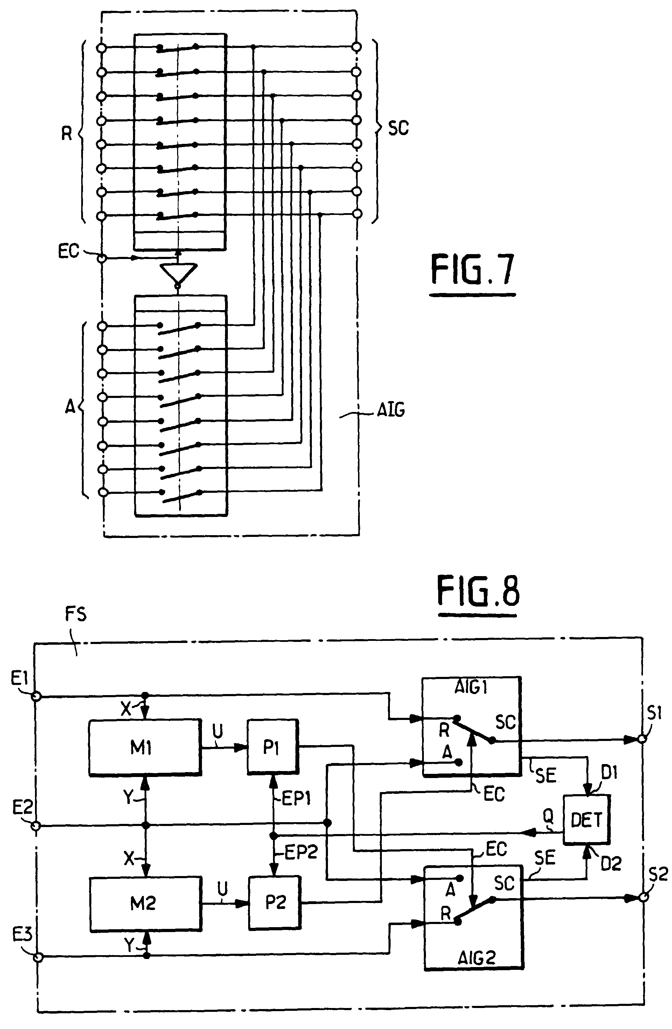

Pour ce qui est de l'aiguilleur AIG1, il peut être du type commutateur de signaux analogiques ou numériques. Il peut ainsi comporter plusieurs commutateurs en parallèle, commandés à l'identique, permettant de transmettre des signaux analogiques ou numériques. Ainsi, la figure 7 représente un aiguilleur AIG parallèle à commande électrique, permettant de commuter des signaux codés sur 8 bits. Cet aiguilleur AIG peut être réalisé en utilisant des circuits logiques multiplexeurs parallèles ou des relais à position repos/travail, ou des commutateurs optiques.

Le sélecteur FS de signaux, tel que décrit précédemment, est apte à masquer un signal d'entrée incorrect. Cependant, dans le cas de double défaut sur ces signaux d'entrée, il risque d'induire en erreur les circuits situés en aval. Pour y remédier, le sélecteur FS de signaux, tel que représenté sur la figure 8, comporte, de plus, des circuits modifiant son comportement, et devient un sélecteur FS de signaux, avec blocage.

Ce sélecteur FS de signaux, avec blocage, a pour but de remédier à deux problèmes non résolus au moyen des sélecteurs FS décrits ci-dessus :
- dans le cas où les signaux Eₛ1 et Eₛ3 d'un sélecteur FS à trois entrées sont incorrects et différents, ce sélecteur FS de signaux à trois entrées se configure de telle sorte que ses deux signaux de sortie Sₛ1 et Sₛ2 sont respectivement identiques aux deux signaux d'entrée Eₛ1 et Eₛ3, et, dans le cas de la réalisation d'un sélecteur de signaux à n entrées, utilisant de tels sélecteurs FS montés en cascade, comme expliqué plus loin, ce cas de figure est gênant car, pour tolérer cette double défaillance (défaillance de Eₛ1 et Eₛ3), il faut deux autres étages en aval formés chacun par un sélecteur FS de signaux à trois entrées et recevant un signal correct sur leur troisième entrée E3 ;
- le sélecteur FS de signaux à trois entrées peut aussi être mis en défaut en cas de défaillance séquentielle de deux signaux d'entrée qui prendraient une valeur incorrecte identique, car les signaux de sortie Sₛ1 et Sₛ2 sont alors formés par les deux signaux d'entrée incorrects et identiques, donc non détectables, en tant que signaux incorrects, par un système placé en aval (par exemple un système duplex ou tout simplement par un autre sélecteur FS de signaux à trois entrées permettant de constituer un sélecteur de signaux à n entrées).

Ce sélecteur FS de signaux, avec blocage, comporte :
- lesdits premier aiguilleur AIG1 et deuxième aiguilleur AIG2 comportant respectivement, de plus, une sortie d'état SE fournissant un signal représentatif de l'état actif ACT ou repos REP dudit aiguilleur AIG1 ou AIG2 ;
- un moyen détecteur DET à deux entrées D1, D2 reliées respectivement à la sortie d'état SE du premier aiguilleur AIG1 et du deuxième aiguilleur AIG2, apte à fournir, sur sa sortie Q, une information significative de la présence à l'état repos REP de l'un au moins des premier A1 et deuxième A2 aiguilleurs ;
- un premier moyen de verrouillage P1, interposé entre la sortie U dudit premier moniteur M1 et l'entrée de commande EC dudit deuxième aiguilleur AIG2, recevant, sur une entrée de commande EP1, ladite information issue de la sortie Q du moyen détecteur DET et permettant audit premier moniteur M1 de commander l'état dudit deuxième aiguilleur AIG2 si ledit moyen détecteur DET n'a pas préalablement détecté qu'au moins un desdits premier aiguilleur AIG1 et deuxième aiguilleur AIG2 est dans son état repos REP, et empêchant ledit premier moniteur M1 de commander ledit deuxième aiguilleur AIG2 si ledit moyen détecteur DET a détecté préalablement qu'un au moins desdits premier aiguilleur AIG1 et deuxième aiguilleur AIG2 est dans son état repos REP ;
- un deuxième moyen de verrouillage P2, interposé entre la sortie U dudit deuxième moniteur M2 et l'entrée de commande EC dudit premier aiguilleur AIG1, recevant, sur une entrée de commande EP2, ladite information issue de la sortie Q du moyen détecteur DET et permettant au dit deuxième moniteur M2 de commander l'état dudit premier aiguilleur AIG1 si ledit moyen détecteur DET n'a pas préalablement détecté qu'au moins un desdits premier aiguilleur AIG1 et deuxième aiguilleur AIG2 est dans son état repos REP, et empêchant ledit deuxième moniteur M2 de commander ledit premier aiguilleur AIG1 si ledit moyen détecteur DET a préalablement dé tecté qu'au moins un desdits premier aiguilleur AIG1 et deuxième aiguilleur AIG2 est dans son état repos REP.

Le sélecteur FS de signaux, avec blocage, remédie ainsi aux problèmes sus-mentionnés en utilisant un mécanisme de blocage supplémentaire, c'est-à-dire qu'à la première reconfiguration due à un signal d'entrée incorrect, ce mécanisme fige cette nouvelle configuration et ainsi empêche toute nouvelle reconfiguration lorsqu'un deuxième signal d'entrée devient incorrect.

Autrement dit, lors d'une première défaillance d'un de ses trois signaux d'entrée Eₛ1, Eₛ2, Eₛ3, le sélecteur FS de signaux avec blocage se configure de telle sorte qu'il isole l'entrée défaillante et fournit sur ses deux sorties S1 et S2 les deux signaux d'entrée indépendants et corrects, mais aussi fige sa nouvelle configuration en bloquant l'état des aiguilleurs AIG1 et AIG2. De ce fait, lors d'une deuxième défaillance d'un de ses trois signaux d'entrée Eₛ1, Eₛ2, Eₛ3, le sélecteur FS de signaux avec blocage étant bloqué, il en résulte qu'un et un seul signal de sortie Sₛ1 ou Sₛ2 est affecté par la deuxième défaillance d'un des trois signaux d'entrée Eₛ1, Eₛ2 ou Eₛ3.

Ainsi, ce signal de sortie incorrect pourra facilement être détecté et isolé par un autre (et un seul) sélecteur FS de signaux à trois entrées placé en aval, qui recevra ainsi, en l'absence d'autre défaut, deux signaux corrects. Un sélecteur de signaux à n entrées formé par n-2 sélecteur FS de signaux en cascade sera ainsi tolérant à n-2 défaillances.

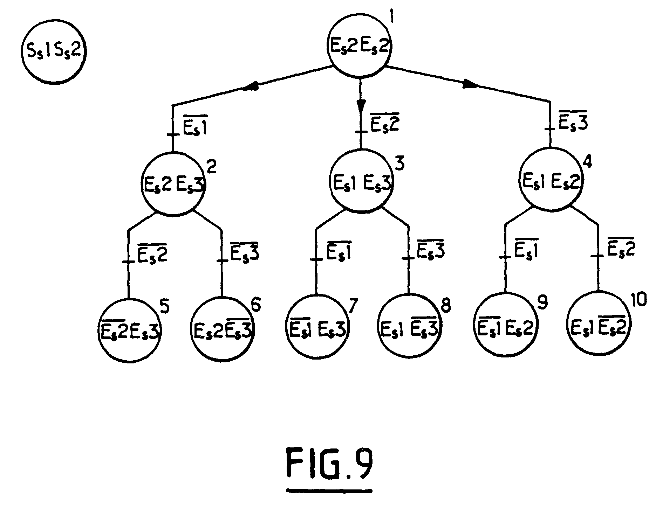

Le fonctionnement détaillé du sélecteur de signaux avec blocage de la figure 8 est décrit ci-après, en regard du graphe de la figure 9 qui indique l'état des sorties S1 et S2. Ce graphe explicite les cas suivants :
1) le sélecteur FS de signaux, avec blocage, n'est pas alimenté par une source de puissance. Alors, les aiguilleurs AIG1 et AIG2 sont à l'état repos REP, comme représenté sur la figure 8 ;
2) les trois signaux Eₛ1, Eₛ2 et Eₛ3 sont corrects (état 1 de la figure 9). Alors, les moniteurs M1 et M2 détectent respectivement l'identité des signaux Eₛ1 et Eₛ2 et celle des signaux Eₛ2 et Eₛ3 et leurs sorties à l'état haut H commandent respectivement les aiguilleurs AIG2 et AIG1 à l'état actif ACT. Il en résulte que, sur les sorties communes SC des aiguilleurs AIG1 et AIG2, apparaissent respectivement des signaux de sortie Sₛ1 et Sₛ2, identiques entre eux et égaux au signal Eₛ2. Le moyen DET détecteur recevant respectivement, sur ses deux entrées D1 et D2, les deux signaux issus respectivement de la sortie d'état SE du premier aiguilleur AIG1 et du deuxième aiguilleur AIG2, significatifs de l'état actif ACT ou repos REP de ces aiguilleurs. Ce moyen détecteur DET détecte, dans le cas présent, qu'aucun aiguilleur AIG1 ou AIG2 n'est dans son état repos REP, et il transmet, par sa sortie Q, cette information sous forme d'un signal de commande aux entrées de commande respective EP1 et EP2 des premier et deuxième moyens de verrouillage P1 et P2, respectivement montés en série entre la sortie U du moniteur M1 ou M2 et l'entrée EC de l'aiguilleur AIG2 ou AIG1 commandé. Ces premier et deuxième moyens de verrouillage P1 et P2 sont aptes à transmettre ou non le signal reçu de la sortie U du moniteur M1 ou M2 associé, selon l'état de ladite commande reçue sur leur entrée de commande EP1 et EP2 ; dans le cas ci-dessus, le signal appliqué aux entrées EP1 et EP2 autorise la transmission du signal Uₛ ;
3) si (état 2 de la figure 9) le signal Eₛ1 est incorrect, alors que les signaux Eₛ2 et Eₛ3 sont corrects (un signal incorrect étant indiqué par son nom surligné sur cette figure 9), le moniteur M1, constatant la différence des signaux Eₛ1 et Eₛ2, a sa sortie U à l'état bas B, ce qui oblige l'aiguilleur AIG2 à avoir l'état repos REP, de sorte que le signal Sₛ2 est égal au signal Eₛ3. Par ailleurs, le moniteur M2, constatant l'identité des signaux Eₛ2 et Eₛ3, sa sortie U à l'état haut H commande l'aiguilleur AIG1 à son état actif ACT. Le signal Sₛ1 est donc égal au signal Eₛ2 ; le moyen détecteur DET détecte que l'aiguilleur AIG2 est dans son état repos REP et transmet, par sa sortie Q, cette information aux premier et deuxième moyens de verrouillage P1 et P2 qui bloquent alors les éventuelles commandes ultérieures issues des sorties U des moniteurs M1 et M2, et, de ce fait, figent le sélecteur FS dans cet état 2 ;
4) si (état 3 de la figure 9) le signal Eₛ2 est incorrect, alors que les signaux Eₛ1 et Eₛ3 sont corrects, on voit que les sorties U des moniteurs M1 et M2 sont à l'état bas B et que les aiguilleurs AIG1 et AIG2 sont à l'état repos REP ; les signaux Sₛ1 et Sₛ2 sont alors égaux respectivement aux signaux Eₛ1 et Eₛ3 ; le moyen détecteur DET détecte que les aiguilleurs AIG1 et AIG2 sont dans leur état repos REP et transmet, par sa sortie Q, cette information aux premier et deuxième moyens de verrouillage P1 et P2, qui bloquent alors les éventuelles commandes ultérieures issues des sorties U des moniteurs M1 et M2, et, de ce fait, figent le sélecteur FS dans cet état 3 ;
5) de même, si (état 4 de la figure 9) le signal Eₛ3 est incorrect, alors que les signaux Eₛ1 et Eₛ2 sont corrects, les sorties U des moniteurs M1 et M2 sont respectivement à l'état haut H et bas B et les aiguilleurs AIG1 et AIG2 sont respectivement à l'état repos REP et actif ACT, de sorte que les signaux Sₛ1 et Sₛ2 sont respectivement égaux aux signaux Eₛ1 et Eₛ2 ; le moyen détecteur DET détecte que l'aiguilleur AIG1 est dans son état repos REP et transmet, par sa sortie Q, cette information aux premier et deuxième moyens de verrouillage P1 et P2, qui bloquent alors les éventuelles commandes ultérieures issues des sorties U des moniteurs M1 et M2, et, de ce fait, figent le sélecteur de signaux dans cet état 4 ;
6) si, après une première défaillance d'un des trois signaux Eₛ1, Eₛ2 ou Eₛ3, comme représenté par les états 2, 3 ou 4 de la figure 9, un deuxième signal d'entrée passe à un état incorrect, un seul de ces signaux d'entrée est correct ; il en résulte qu'un et un seul signal de sortie Sₛ1 ou Sₛ2 est affecté par la deuxième défaillance d'un des trois signaux d'entrée Eₛ1, Eₛ2 ou Eₛ3, comme représenté par les états 5, 6, 7, 8, 9 et 10 de la figure 9, car l'état du sélecteur FS de signaux a été figé par les premier et deuxième moyens de verrouillage P1 et P2 lors de la première défaillance (cas 3, 4 ou 5 cités précédemment) ;
7) enfin, si les trois signaux d'entrée Eₛ1, Eₛ2 et Eₛ3 sont incorrects, les deux signaux de sortie Sₛ1 et Sₛ2 sont formés par deux signaux incorrects, et différents dans le cas général, cette situation n'étant pas représentée sur la figure 9.

De façon préférable, ce sélecteur FS de signaux à trois entrées, avec blocage, comporte, en sortie des moniteurs M1 et M2, un comparateur à seuil C et un temporisateur DT, afin d'éviter que le moyen détecteur DET ne mémorise un passage à l'état repos REP de l'aiguilleur AIG1 ou AIG2 qui ne serait que transitoire, à la suite d'une légère discordance entre deux signaux d'entrée.

Selon un exemple d'application du sélecteur FS de signaux à trois entrées précédemment décrit, on réalise un sélecteur de signaux GS à n entrées I1 à In et à deux sorties S1 et S2 en formant une cascade de n-2 tels sélecteurs FS de signaux à trois entrées, identiques entre eux.

La variante de réalisation du sélecteur FS de signaux à trois entrées, avec blocage, est la plus appropriée. D'autres réalisations de sélecteurs GS, n'utilisant pas de sélecteurs FS avec blocage, sont cependant possibles. De ce fait, la représentation du sélecteur GS dans les figures suivantes est schématique, et ne représente que sa structure de base.

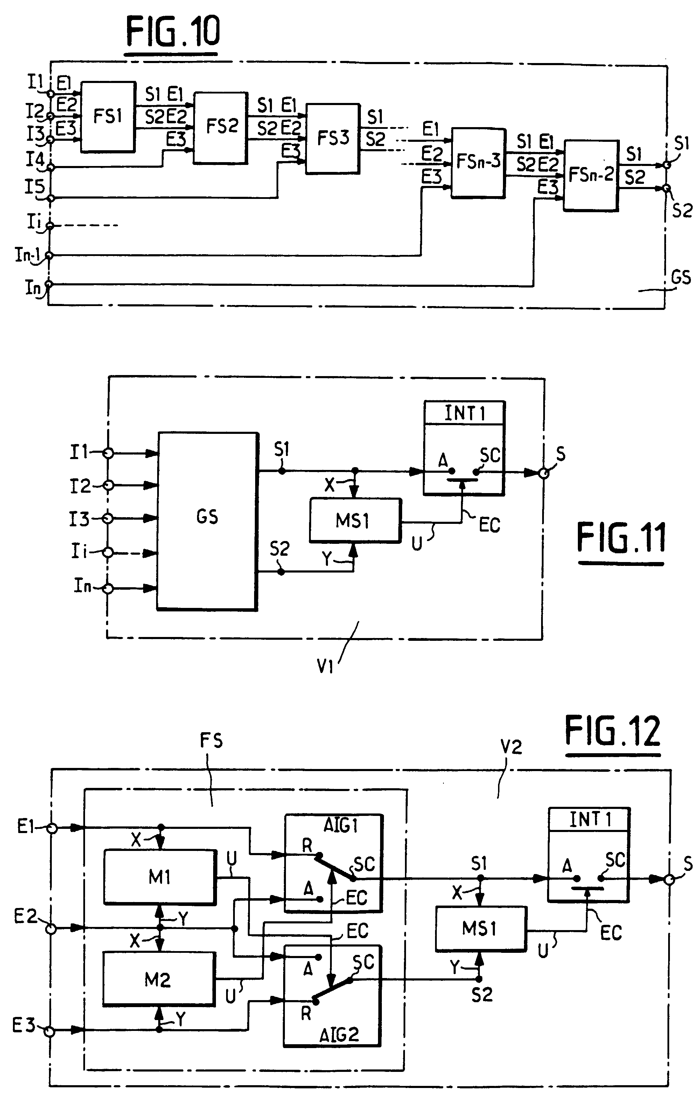

Dans le sélecteur de signaux GS à n entrées montré schématiquement sur la figure 10, on retrouve une pluralité de n-2 sélecteurs FS, avec ou sans blocage, de signaux à trois entrées, portant respectivement les références FS1, FS2, FS3, ..., FSi, ..., FSn-2. Ces sélecteurs FSi de signaux à trois entrées sont montés en cascade de façon à former le sélecteur de signaux GS à n entrées I1 à In et à deux sorties, ces deux dernières étant celles S1 et S2 du sélecteur FSn-2 de signaux à trois entrées qui est le plus en aval.

Les entrées E1, E2, E3 du premier sélecteur FS1 de signaux à trois entrées, situé le plus en amont, sont respectivement reliées aux entrées I1, I2 et I3, tandis que les sorties S1 et S2 du premier sélecteur FS1 de signaux à trois entrées sont respectivement reliées aux entrées E1 et E2 du deuxième sélecteur FS2 de signaux à trois entrées. La troisième entrée E3 du deuxième sélecteur FS2 de signaux à trois entrées est reliée à l'entrée I4. De façon plus générale, les entrées E1 et E2 du sélecteur FSi de signaux à trois entrées de rang i dans la cascade (avec 1<i≤n-2), sont reliées respectivement aux sorties S1 et S2 du sélecteur FSi-1 de signaux à trois entrées, de rang immédiatement inférieur, tandis que la troisième entrée E3 de ce sélecteur FSi de signaux à trois entrées est reliée à l'entrée Ii+2. Si tous les signaux apparaissant aux entrées I1 à In sont corrects, la table de vérité de la figure 2 permet de comprendre que les signaux apparaissant aux sorties du sélecteur de signaux GS à n entrées de la figure 10, c'est-à-dire sur les sorties S1 et S2 du sélecteur FSn-2 de signaux à trois entrées, sont chacun constitués par le signal Eₛ2 appliqué sur l'entrée I2.

Le fonctionnement d'un sélecteur de signaux GS à n entrées, réalisé à partir de n-2 sélecteurs FS sans blocage en cascade, peut facilement se déduire à partir du fonctionnement du sélecteur FS de signaux à trois entrées représenté à la figure 1, où chaque sélecteur de signaux à trois entrées (FS1, FS2, FS3, ..., FSi, ..., FSn-2) constituant ledit sélecteur de signaux GS à n entrées est identique à celui décrit précédemment.

En effet, on voit d'après la table de vérité de la figure 2, que chaque sélecteur FSi de signaux à trois entrées transmet deux signaux Sₛ1 et Sₛ2 corrects tant qu'il n'y a pas plus d'un signal incorrect en entrée ; chaque étage de ce montage en cascade est ainsi apte à éliminer un défaut apparaissant sur l'une des n entrées. Par exemple, si l'ensemble des signaux I3 à In est incorrect, chacun des n-2 sélecteurs FSi de signaux à trois entrées effectue le choix des deux signaux corrects qu'il reçoit et élimine le troisième qui est incorrect.

Par contre, si au moins deux des trois signaux I1, I2, I3 appliqués sur le premier sélecteur FS1 de signaux à trois entrées sont incorrects, les sorties S1 et S2 de ce premier sélecteur FS1 de signaux à trois entrées fournissent les signaux I1 et I3, c'est-à-dire un ou deux signaux incorrects. Dans le cas où I1 et I3 sont incorrects tous les deux, le deuxième sélecteur FS2 de signaux à trois entrées reçoit donc ces deux signaux I1 et I3 incorrects sur ses entrées E1 et E2, et le signal I4 sur son entrée E3. Il fournit donc, d'après la table de vérité de la figure 2, les deux signaux reçus sur sa première E1 et troisième E3 entrée, c'est-à-dire I1, incorrect, et I4, correct a priori, sur ses sorties respectives S1 et S2.

Le troisième sélecteur FS3 de signaux à trois entrées reçoit alors les signaux I1, incorrect, I4, correct a priori, et I5, correct a priori. Il va donc transmettre les signaux I4 et I5 ; on a ainsi éliminé, de la chaîne de propagation, les signaux I1 et I3 incorrects. On voit ainsi que l'élimination des signaux incorrects se réalise grâce à l'introduction, dans la chaîne de propagation, de signaux corrects sur l'entrée E3 des sélecteurs FSi de signaux à trois entrées, la deuxième introduction d'un signal correct étant détectée par comparaison, ce qui établit une transmission de deux signaux corrects.

Selon un exemple d'application dudit sélecteur de signaux GS à n entrées, on réalise un voteur V1 à n entrées représenté sur la figure 11, comportant :
- un sélecteur de signaux GS à n entrées, tel que décrit précédemment ;
- un premier interrupteur INT1, pourvu d'une entrée active A et d'une entrée de commande EC apte à mettre, ou non, ladite entrée active A en relation avec une sortie commune SC selon que ce premier interrupteur INT1 est respectivement à l'état actif ou à l'état repos, en fonction du signal appliqué sur ladite entrée de commande EC, ladite entrée active A et ladite sortie commune SC dudit premier interrupteur INT1 étant respectivement reliées à ladite sortie S1 dudit sélecteur de signaux GS à n entrées et à la sortie dudit voteur V1 à n entrées, c'est-à-dire que ce premier interrupteur INT1 peut avoir un état actif pour lequel sa sortie commune SC est reliée à son entrée active A, et un état repos pour lequel sa sortie SC n'est pas reliée ; il peut avoir la même constitution qu'un aiguilleur AIG1 qui n'aurait pas d'entrée de repos R ;
- un premier moniteur de sortie MS1, identique auxdits premier et deuxième moniteurs M1 et M2, dont les deux entrées X et Y sont respectivement reliées auxdites sorties S1 et S2 dudit sélecteur de signaux GS à n entrées pour mesurer l'écart entre les signaux apparaissant sur ces sorties S1 et S2, la sortie U dudit premier moniteur de sortie MS1 étant reliée à l'entrée de commande EC dudit premier interrupteur INT1, et étant susceptible de commander l'état dudit premier interrupteur INT1.

Ainsi, ledit sélecteur de signaux GS à n entrées, constitué de n-2 (avec n≥3) sélecteurs FS de signaux à trois entrées en cascade, forme un premier étage qui configure automatiquement les n entrées en deux signaux intermédiaires Sₛ1 et Sₛ2, isolant les éventuels signaux d'entrée défaillants, ce qui est favorable à la fiabilité opérationnelle. Avantageusement, la réalisation de ce premier étage, à partir de n-2 sélecteurs FSi de signaux, avec blocage, en cascade, permet d'obtenir un système masquant la défaillance de n-2 signaux d'entrée parmi les n signaux d'entrée issus de n sous-systèmes redondants, ainsi que celle des sélecteurs FSi de signaux à trois entrées associés qui constituent le premier étage. Par ailleurs, ledit premier moniteur de sortie MS1 et ledit premier interrupteur INT1 forment un second étage qui compare les deux signaux intermédiaires Sₛ1 et Sₛ2 transmis par le premier étage, pour détecter une n-1ème défaillance, afin d'isoler la sortie du voteur à n entrées, le premier interrupteur INT1 coupant alors la connexion entre sa sortie commune SC et ladite entrée active A s'il y a désaccord entre lesdits signaux intermédiaires Sₛ1 et Sₛ2. On augmente ainsi la sécurité. En amont du premier étage du voteur V1 à n entrées se trouve une structure comportant une redondance d'ordre n de sous-systèmes, méthode pour augmenter la fiabilité opérationnelle d'un système, alors qu'en aval de ce premier étage se trouve une structure duplex permettant de contrôler la cohérence des deux signaux de sortie Sₛ1 et Sₛ2 de ce premier étage, au moyen du second étage.

Dans le but de simplifier la compréhension du fonctionnement du voteur V1 à n entrées, l'exposé de son fonctionnement est fait à partir d'un voteur V2 à trois entrées dont le premier étage est constitué d'un seul sélecteur FS de signaux à trois entrées.

Ainsi, le voteur V2 à trois entrées, conforme à la présente invention et montré sur la figure 12, comporte le sélecteur FS de signaux à trois entrées décrit précédemment, dont les entrées E1, E2, E3 forment les trois entrées dudit voteur V2 à trois entrées, qui par ailleurs est pourvu d'une sortie S. En plus du sélecteur FS, le voteur V2 à trois entrées comporte :
- ledit premier interrupteur INT1, pourvu d'une entrée active A, d'une entrée de commande EC et d'une sortie commune SC, ladite entrée active A et ladite sortie commune SC dudit premier interrupteur INT1 étant respectivement reliées à ladite sortie commune SC dudit premier aiguilleur AIG1 et à la sortie S dudit voteur V2 à trois entrées ; et
- ledit premier moniteur de sortie MS1 à deux entrées X et Y respectivement reliées auxdites sorties communes SC desdits premier et deuxième aiguilleurs AIG1 et AIG2 et susceptible de commander, par sa sortie U, l'entrée de commande EC du premier interrupteur INT1.

Tout comme pour les moniteurs M1 et M2, la sortie U du premier moniteur de sortie MS1 peut prendre un état bas B ou un état haut H et commander le premier interrupteur INT1 à l'état actif ACT, lorsqu'elle est dans son état haut H, et le commander à l'état repos REP, lorsqu'elle est dans son état bas B, ce qui isole alors sa sortie SC de son entrée active A.

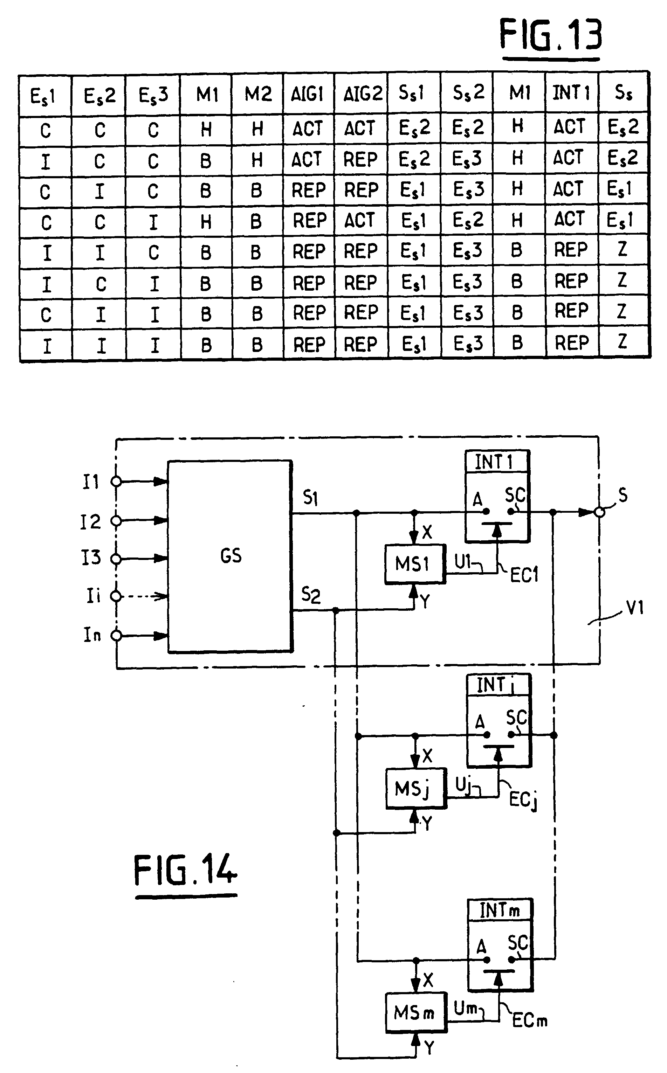

Le fonctionnement du voteur V2 à trois entrées de la figure 12 est décrit ci-après, en regard de la table de vérité de la figure 13, qui inclut celle de la figure 2. Dans cette table de vérité, le signal de sortie de ce voteur V2 est désigné par la référence Sₛ. On reprend ci-après les différents cas pouvant se produire :
1) ledit voteur V2 à trois entrées n'est pas alimenté par une source de puissance. Alors, les aiguilleurs AIG1 et AIG2 et le premier interrupteur INT1 sont à l'état repos REP, de sorte que la sortie S est isolée des entrées E1, E2, E3, comme représenté par la figure 12 ;
2) les trois signaux Eₛ1, Eₛ2 et Eₛ3 sont corrects. On a vu qu'alors les signaux de sortie Sₛ1 et Sₛ2 du sélecteur FS de signaux à trois entrées sont égaux au signal Eₛ2. Le premier moniteur de sortie MS1 constate l'égalité des signaux Sₛ1 et Sₛ2, et sa sortie U est à l'état haut H et force l'interrupteur INT1 à l'état actif ACT. Le signal de sortie Sₛ est donc égal au signal Eₛ2 ;
3) le signal Eₛ1 est incorrect, alors que les signaux Eₛ2 et Eₛ3 sont corrects. On a vu qu'alors le signal de sortie Sₛ2 est égal au signal Eₛ3 et que le signal de sortie Sₛ1 est égal au signal Eₛ2. Il en résulte que les signaux de sortie Sₛ1 et Sₛ2 sont identiques et que le premier interrupteur INT1 est à l'état actif ACT sous la commande de la sortie U du premier moniteur de sortie MS1. Le signal de sortie Sₛ du voteur V2 est donc égal au signal Eₛ2 ;
4) si le signal Eₛ2 est incorrect, alors que les signaux Eₛ1 et Eₛ3 sont corrects, on a vu que les signaux de sortie Sₛ1 et Sₛ2 sont égaux respectivement aux signaux Eₛ1 et Eₛ3, de sorte que la sortie U du premier moniteur de sortie MS1 est à l'état haut H et que le premier interrupteur INT1 est à l'état actif ACT, le signal de sortie Sₛ du voteur V2 étant alors égal au signal Eₛ1 ;
5) de même, si le signal Eₛ3 est incorrect, alors que les signaux Eₛ1 et Eₛ2 sont corrects, on a vu que les signaux Sₛ1 et Sₛ2 sont respectivement formés par les signaux Eₛ1 et Eₛ2, de sorte que la sortie du premier moniteur de sortie MS1 est à l'état haut H et l'interrupteur IN T1 à l'état actif ACT, le signal de sortie Sₛ du voteur V2 étant alors égal au signal Eₛ1 ;
6) si deux des signaux Eₛ1, Eₛ2, Eₛ3 sont incorrects et non identiques, un seul d'entre eux étant correct, on a vu que les signaux Sₛ1 et Sₛ2 sont respectivement égaux aux signaux différents Eₛ1 et Eₛ3, de sorte que la sortie U du premier moniteur de sortie MS1, à l'état bas B, force le premier interrupteur INT1 à l'état repos REP. La sortie S du voteur V2 est alors isolée des entrées E1, E2, E3 ; dans la table de vérité de la figure 13, l'isolement de la sortie S est symbolisé par la lettre Z ;
7) enfin, si les trois signaux Eₛ1, Eₛ2, Eₛ3 sont incorrects, on a vu que les signaux Sₛ1 et Sₛ2 sont respectivement formés par les signaux Eₛ1 et Eₛ3, non identiques en général, de sorte que la sortie S est isolée des entrées E1, E2, E3.

Comme expliqué précédemment, il est souhaitable de temporiser la sortie des moniteurs M1 et M2, et aussi celle du premier moniteur de sortie MS1, de façon à éviter des commutations intempestives dues à des discordances passagères, d'autant plus nombreuses qu'il y a plus d'entrées et qui feraient passer à l'état verrouillé des sélecteurs FSi de signaux à trois entrées, avec blocage. Cette temporisation peut n'être effectuée que sur le premier moniteur MS1 de sortie, dans la mesure où le système aval utilisant le signal issu du voteur V1 peut tolérer des micro-coupures sur ce signal, dues à des commutations dans le premier étage.

Comme indiqué précédemment, le premier étage du voteur V2 à n entrées est tolérant à ses n-2 défaillances. Pour qu'il en soit de même de l'ensemble de ce voteur V2 à n entrées, il est avantageux de prévoir une duplication du second étage, comme cela est illustré sur la figure 14, qui comporte :
- m interrupteurs INTj (j entier = 1 à m), chacun pourvu d'une entrée active A, d'une entrée de commande EC et d'une sortie commune SC, ladite entrée active A et ladite sortie commune SC desdits m interrupteurs INTj étant respectivement reliées à ladite sortie S1 dudit sélecteur de signaux GS à n entrées et à la sortie S dudit voteur à n entrées ; et
- m moniteurs de sortie MS1, ..., MSj, ..., MSm à deux entrées X,Y, dont l'une, X, des deux entrées est reliée à l'une, S1, des sorties dudit sélecteur de signaux GS à n entrées et dont l'autre, Y, des deux entrées est reliée à l'autre, S2, des sorties dudit sélecteur de signaux GS à n entrées, pour mesurer l'écart entre les signaux Sₛ1, Sₛ2 apparaissant sur lesdites sorties S1 et S2, et susceptibles de commander, par leur sortie Uj, l'entrée de commande ECj de l'interrupteur associé INTj de même rang j.

Ainsi, le second étage du voteur à n entrées selon l'invention comporte m ensembles moniteur de sortie MSj et interrupteur INTj identiques, montés en parallèle, permettant d'éviter les effets de m-1 pannes à l'état repos des ensembles moniteur de sortie MSj et interrupteur INTj.

En pratique, la probabilité de défaut d'un ensemble moniteur de sortie MSj et interrupteur INTj est faible devant la probabilité de défaut d'un sélecteur de l'étage d'entrée et des sous-systèmes associés, du fait que ces sous-systèmes comportent usuellement de nombreux composants. De ce fait, une redondance m d'ordre inférieur à n suffit, d'autant plus qu'un nombre m de moniteurs de sortie MSj et d'interrupteurs INTj excessif va à l'encontre de la sécurité, car la présence d'un seul moniteur de sortie Mj et interrupteur INTj en panne à l'état actif empêche les autres d'isoler la sortie S du voteur à n entrées par rapport au monde. Par exemple, on peut simplement réaliser le second étage du voteur à n entrées avec m = 2 ensembles moniteur de sortie MSj et interrupteur INTj, montés en parallèle, permettant ainsi d'éviter les effets d'une panne à l'état repos de l'un des deux. L'homme de métier connaît cependant des montages séries et parallèles d'interrupteurs permettant de tolérer un blocage à l'état actif ACT.

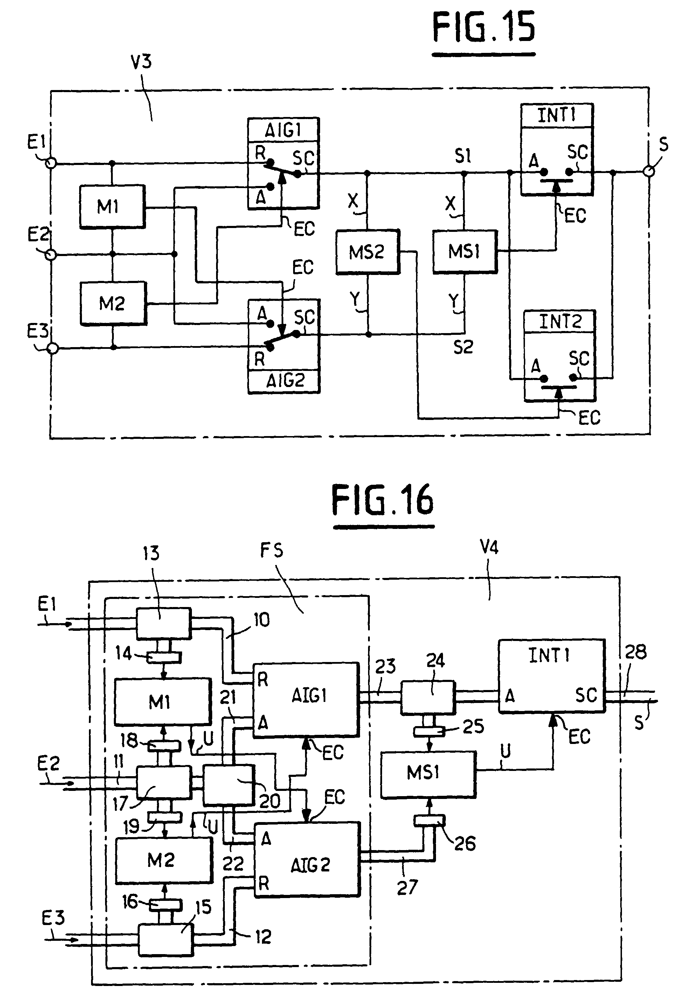

La figure 15 montre, à titre d'exemple, une réalisation d'un voteur V3 à trois entrées totalement tolérant à une défaillance du système complet constitué de trois sous-systèmes redondants (non représentés), fournissant les signaux appliqués aux entrées E1, E2 et E3, et du voteur V3.

Il est à noter que les entrées actives A des interrupteurs INT1 et INT2 peuvent être reliées à l'une ou l'autre des sorties S1 ou S2 du sélecteur de signaux GS, puisque la sortie S du voteur V3 transmet l'un des deux signaux apparaissant sur ces sorties S1 ou S2, lorsque ces signaux sont identiques, et aucun lorsqu'ils sont différents.

De même, il est envisageable de relier l'entrée active A de certains interrupteurs INTj à la sortie S1, et l'entrée active A des autres interrupteurs INTj à la sortie S2, ce qui fournit une liaison redondante permettant de tolérer la coupure de la liaison allant de la sortie S1 aux entrées actives A des interrupteurs INTj. Ceci suppose cependant que deux des signaux appliqués aux entrées E1 à E3 puissent être reliés, au niveau de la sortie S du voteur V3.

Sur la figure 16, on a représenté un mode de réalisation d'un tel voteur V1 sous forme électro-optique V4. Dans ce cas, les aiguilleurs AIG1 et AIG2 à deux voies sont des multiplexeurs optiques à commande électrique, l'interrupteur INT1 pouvant être du même type, avec une seule entrée utilisée, alors que les moniteurs M1, M2 et MS1 sont de type électrique, tel que décrit précédemment.

Les entrées optiques E1, E2 et E3 sont respectivement reliées aux aiguilleurs optiques AIG1 et AIG2 et à l'interrupteur INT1 par des fibres optiques 10, 11 et 12. Sur la fibre optique 10, alimentant l'entrée de repos R de l'aiguilleur AIG1, est prévu un coupleur optique 13 en "Y" dont la branche dérivée commande une cellule photoélectrique 14 constituant l'entrée X du moniteur M1. De même, sur la fibre optique 12, reliée à l'entrée de repos R de l'aiguilleur AIG2, est prévu un coupleur optique 15 en "Y" dont la branche dérivée commande une cellule photoélectrique 16 constituant l'entrée Y du moniteur M2. La fibre optique 11, reliée à l'entrée E2, alimente un coupleur optique 17 en "Y", à deux branches dérivées qui commandent respectivement des cellules photoélectriques 18 et 19 formant respectivement les entrées Y du moniteur M1 et X du moniteur M2. De plus, le coupleur optique 17 alimente en énergie optique un coupleur optique 20, qui est relié aux entrées actives A des aiguilleurs AIG1 et AIG2 par des fibres optiques 21 et 22, respectivement. Les coupleurs optiques 17 et 20 peuvent être constitués d'un seul composant à quatre sorties.

La sortie de l'aiguilleur AIG1 est reliée à l'entrée active A de l'interrupteur INT1 par une fibre optique 23, sur laquelle est monté un coupleur optique 24 en "Y" dont la branche dérivée commande une cellule photoélectrique 25 constituant l'entrée X du premier moniteur de sortie MS1. La sortie de l'aiguilleur AIG2 est reliée à une cellule photoélectrique 26 par une fibre optique 27, ladite cellule 26 formant l'entrée Y du premier moniteur de sortie MS1.

La sortie S de ce voteur V4 est formée par une fibre optique 28 reliée à la sortie SC de l'interrupteur INT1. Les moniteurs M1, M2 et MS1 commandent respectivement, par leur sortie U, l'entrée de commande EC des aiguilleurs AIG2 et AIG1 et de l'interrupteur INT1.

Il est possible de réaliser un tel voteur V4 électro-optique comportant plusieurs fibres en parallèle, en dupliquant les fibres optiques, les coupleurs et interfaces électro-optiques et en utilisant des aiguilleurs et interrupteurs optiques capables de commuter plusieurs fibres, par exemple des relais électro-optiques repos/ travail à plusieurs fibres en sortie, comme schématisé sur la figure 7, ou une association de plusieurs tels relais à une seule fibre de sortie. L'interrupteur INT1 peut être réalisé de la même manière, avec des relais optiques à état actif passant.

Un tel voteur V4 peut évidemment comporter les diverses adjonctions de seuil, temporisation et blocage précédemment exposées.

On constate aisément que le fonctionnement de ce voteur électro-optique V4 est identique à celui du voteur V1 décrit précédemment.

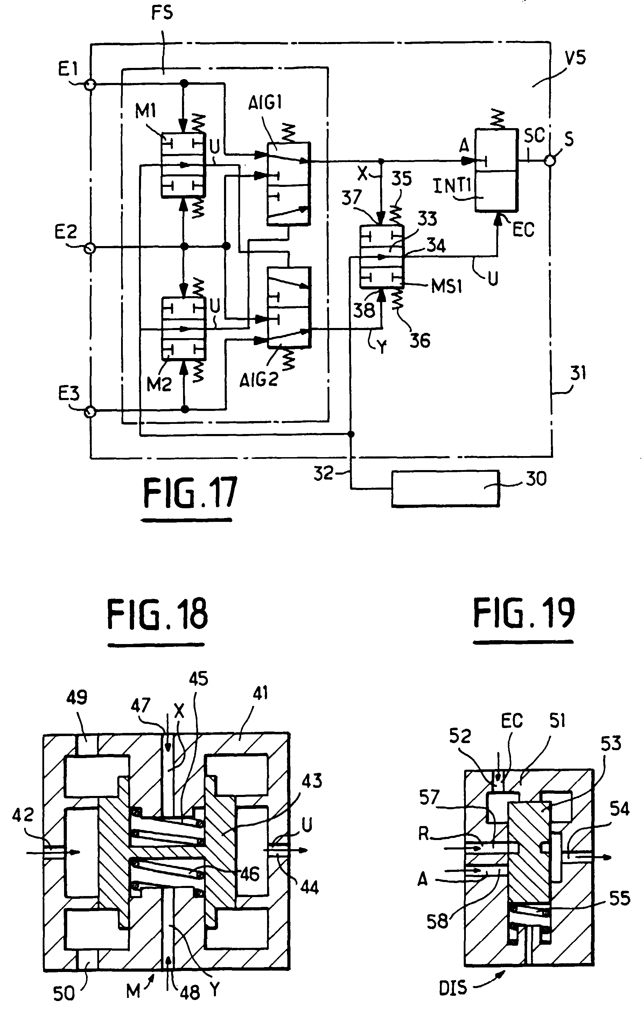

Sur la figure 17, on a représenté un mode de réalisation d'un tel voteur V1 sous forme hydraulique (ou encore pneumatique) V5 comportant une source de fluide sous pression 30 appliquée à un boîtier 31 comportant une entrée 32 d'alimentation, source qui peut être remplacée par trois sources indépendantes alimentant chacune un moniteur M1, M2, MS1, ce qui permet de tenir compte aussi des défaillances possibles d'alimentation.

On comprend facilement que chacun de ces moniteurs M1, M2, MS1, pour une réalisation hydraulique, peut consister, schématiquement, en un tiroir 33 faisant communiquer l'entrée d'alimentation 32 et la sortie U 34 du moniteur, uniquement lorsqu'il est en position centrale. Ce tiroir 33 est maintenu dans cette position centrale grâce à deux ressorts antagonistes 35 et 36 commandés par les deux signaux Xₛ et Yₛ contrôlés, appliqués aux entrées X et Y, respectivement repérées 37 et 38, ceci tant que les signaux contrôlés Eₛ1, Eₛ2, Eₛ3 sont corrects, et est repoussé d'un côté ou de l'autre, interrompant la communication entre l'entrée d'alimentation 32 et la sortie U 34 du moniteur M, dès qu'une différence se présente entre les deux des signaux Eₛ1, Eₛ2, Eₛ3 contrôlés par le moniteur M concerné.

La figure 18 présente schématiquement un exemple de réalisation d'un moniteur pneumatique M1, M2, MS1, formé par un distributeur M, constitué d'un boîtier 41, d'un orifice d'entrée 42 d'alimentation et comportant un piston mobile 43 se déplaçant dans ce boîtier 41 et commandant la mise sous pression d'un orifice de sortie 44, piston soumis à l'action antagoniste de deux ressorts 45 et 46, comme dans le cas du moniteur M hydraulique précédent, et commandé par les deux signaux Xₛ et Yₛ contrôlés appliqués aux entrées X et Y, respectivement repérées 47 et 48. Suivant les valeurs respectives des pressions des signaux Xₛ et Yₛ, le piston 43 met en communication l'un avec l'autre l'orifice d'entrée 42 d'alimentation du boîtier 41 recevant la pression de la source 30 et l'orifice de sortie 44 dudit boîtier 31 constituant la sortie U du moniteur M, ou bien met cette sortie U 44 en communication avec l'atmosphère à travers des orifices 49 ou 50.

Tout comme pour une réalisation électronique, il est possible de créer un seuil sur l'action du moniteur M, en ayant des ressorts 45 et 46 non fortement comprimés à l'état d'équilibre du moniteur M1, ce qui nécessite la fourniture d'un travail pour comprimer l'un des ressorts 45 ou 46, l'autre ressort ne compensant pas l'effort de compression par sa propre détente.

De même, l'action du moniteur M peut être temporisée par utilisation, par exemple, d'orifices de faible diamètre, ne permettant qu'un passage à faible débit du fluide.

De même encore, les aiguilleurs peuvent être bloqués après une première reconfiguration résultant de l'apparition d'une première défaillance, ce qui permet de retrouver le même fonctionnement que le voteur avec blocage.

De plus, chaque aiguilleur AIG1 et AIG2 à deux voies est constitué par un distributeur DIS représenté sur la figure 19 formé d'un boîtier 51 comportant un orifice d'entrée de commande EC, repéré 52, et un piston mobile 53 apte à se déplacer dans ce boîtier 51, sous l'action de la pression transmise par ladite entrée de commande EC 52 à laquelle s'oppose celle d'un ressort 55. Suivant la valeur de la pression dudit signal EC, le piston 53 met en communication l'un ou l'autre de deux orifices d'entrée de signal 57 et 58 du boîtier 51 avec l'orifice de sortie 54, lesdits orifices d'entrée de signal 57 et 58 correspondant respectivement aux entrées de repos R et active A.

Les aiguilleurs AIG et interrupteurs INT hydrauliques et pneumatiques décrits ci-dessus peuvent être rendus aptes à commuter plusieurs signaux en parallèle, en dupliquant les éléments nécessaires à chaque signal.

Là encore, on constate facilement que le fonctionnement du voteur V5 de la figure 17 est semblable à celui du voteur V1 décrit précédemment.

## Revendications

1. Sélecteur (FS) de signaux comportant une première entrée (E1), une deuxième entrée (E2) et une troisième entrée (E3) aptes à recevoir respectivement un premier signal (Eₛ1), un deuxième signal (Eₛ2) et un troisième signal (Eₛ3) et comportant une première sortie (S1) et une seconde sortie (S2),
caractérisé en ce qu'il comporte :
- un premier aiguilleur (AIG1) à deux voies, pourvu d'une entrée active (A), d'une entrée de repos (R), et d'une entrée de commande (EC) apte à recevoir un signal de commande forçant, selon son état, ledit premier aiguilleur (AIG1) à un état actif (ACT) ou à un état repos (REP), et d'une sortie commune (SC), ladite entrée de repos (R) et ladite entrée active (A) dudit premier aiguilleur (AIG1) étant respectivement reliées auxdites première entrée (E1) et deuxième entrée (E2) dudit sélecteur (FS) de signaux, tandis que ladite sortie commune (SC) dudit premier aiguilleur (AIG1) est reliée à ladite première sortie (S1) du sélecteur (FS) de signaux, cette sortie commune (SC) transmettant le signal appliqué sur l'entrée active (A) lorsque ledit premier aiguilleur (AIG1) est à l'état actif (ACT), et transmettant le signal appliqué sur l'entrée de repos (R) lorsque ledit premier aiguilleur (AIG1) est à l'état repos (REP) ;
- un deuxième aiguilleur (AIG2) à deux voies, pourvu d'une entrée active (A), d'une entrée de repos (R), et d'une entrée de commande (EC) apte à recevoir un signal de commande forçant, selon son état, ledit aiguilleur (AIG2) à un état actif (ACT) ou à un état repos (REP), et d'une sortie commune (SC), ladite entrée active (A) et ladite entrée de repos (R) dudit deuxième aiguilleur (AIG2) étant respectivement reliées auxdites deuxième entrée (E2) et troisième entrée (E3) dudit sélecteur (FS) de signaux, tandis que ladite sortie commune (SC) dudit deuxième aiguilleur (AIG2) est reliée à ladite seconde sortie (S2) du sélecteur (FS) de signaux, cette sortie commune (SC) transmettant le signal appliqué sur l'entrée active (A) lorsque ledit deuxième aiguilleur (AIG2) est à l'état actif (ACT), et transmettant le signal appliqué sur l'entrée de repos (R) lorsque ledit deuxième aiguilleur (AIG2) est à l'état repos (REP) ;
- un premier moniteur (M1) à deux entrées (X, Y) respectivement reliées auxdites première entrée (E1) et deuxième entrée (E2) dudit sélecteur (FS) de signaux, apte à mesurer l'écart entre lesdits premier signal (Eₛ1) et deuxième signal (Eₛ2) et dont la sortie (U) est reliée à l'entrée de commande (EC) dudit deuxième aiguilleur (AIG2) et est susceptible de commander l'état de ce deuxième aiguilleur (AIG2) ; et
- un deuxième moniteur (M2) à deux entrées (X, Y) respectivement reliées auxdites deuxième entrée (E2) et troisième entrée (E3) dudit sélecteur (FS) de signaux, apte à mesurer l'écart entre lesdits deuxième signal (Eₛ2) et troisième signal (Eₛ3) et dont la sortie (U) est reliée à l'entrée de commande (EC) dudit premier aiguilleur (AIG1) et est susceptible de commander l'état de ce premier aiguilleur (AIG1);
l'état des sorties (U) desdits moniteurs (M1, M2) et l'état desdits aiguilleurs (AIG1, AIG2) étant, lorsque l'un desdits premier, deuxième ou troisième signaux (Eₛ1, Eₛ2, Eₛ3) est incorrect, représentatifs de l'identité de l'entrée (E1, E2, E3) transmettant un signal incorrect.

2. Sélecteur (FS) de signaux selon la revendication 1, dans lequel lesdits moniteurs (M) sont du type apte à traiter des signaux analogiques ou numériques, séries ou parallèles,
caractérisé en ce que chacun desdits moniteurs (M) comprend :
- des moyens différenciateurs (D) pour mesurer la différence entre les signaux appliqués aux entrées (X, Y) dudit moniteur (M) ;
- des moyens comparateurs (C), pour comparer ladite différence à un seuil prédéterminé (TC⁺, TC⁻) et engendrer un signal d'erreur si la valeur absolue de ladite différence est supérieure à la valeur absolue dudit seuil (TC⁺, TC⁻).

3. Sélecteur (FS) de signaux selon la revendication 1 ou 2,
caractérisé en ce que des moyens temporisateurs (DT) sont interposés en série sur la sortie (U) d'au moins un moniteur (M).

4. Sélecteur (FS) de signaux selon l'une quelconque des revendications 1 à 3,
caractérisé en ce que chaque aiguilleur (AIG) à deux voies est du type commutateur électrique ou dispositif de commutation électrique constitué de plusieurs éléments de commutation identiques disposés en parallèle.

5. Sélecteur (FS) de signaux selon l'une quelconque des revendications 1 à 3,
caractérisé en ce que chaque aiguilleur (AIG) à deux voies est du type multiplexeur optique à commande électrique ou commutateur optique à commande électrique constitué de plusieurs éléments de commutation optique identiques disposés en parallèle.

6. Sélecteur (FS) de signaux selon l'une quelconque des revendications 1 à 3,
caractérisé en ce que chaque aiguilleur (AIG) à deux voies est du type commutateur hydraulique ou pneumatique ou commutateur hydraulique ou pneumatique constitué de plusieurs éléments de commutation identiques disposés en parallèle.

7. Sélecteur (FS) de signaux selon la revendication 6, dans lequel lesdits moniteurs (M) sont aptes à traiter des signaux de pression fluide,
caractérisé en ce que chacun desdits moniteurs (M) comporte un organe (43) soumis à l'action antagoniste des signaux apparaissant aux entrées de signal (X, Y) dudit moniteur (M) et commandant le passage de fluide entre une source de pression (30) et la sortie (U) dudit moniteur (M).

8. Sélecteur (FS) de signaux selon la revendication 6 ou 7,
caractérisé en ce que chacun desdits aiguilleurs (AIG) comporte un organe (53), soumis à l'action du signal appliqué à l'entrée de commande (EC) dudit aiguilleur (AIG), ledit organe (53) étant apte à mettre en communication l'un ou l'autre de deux orifices d'entrée de signal (57,58) avec un orifice de sortie (54).

9. Sélecteur (FS) de signaux selon l'une quelconque des revendications 1 à 8,
caractérisé en ce que :
- le premier aiguilleur (AIG1) et le deuxième aiguilleur (AIG2) comportent respectivement, de plus, une sortie d'état (SE) fournissant un signal représentatif de l'état actif (ACT) ou repos (REP) dudit aiguilleur (AIG1, AIG2) ;
et en ce qu'il comporte :
- un moyen détecteur (DET) à deux entrées (D1,D2) reliées respectivement à la sortie d'état (SE) du premier aiguilleur (AIG1) et du deuxième aiguilleur (AIG2), apte à fournir, sur sa sortie (Q), une information significative de la présence à l'état repos (REP) de l'un au moins des premier aiguilleur (AIG1) et deuxième aiguilleur (AIG2) ;
- un premier moyen de verrouillage (P1), interposé entre la sortie (U) dudit premier moniteur (M1) et l'entrée de commande (EC) dudit deuxième aiguilleur (AIG2), recevant, sur une entrée de commande (EP1), ladite information issue de la sortie (Q) du moyen détecteur (DET) et permettant audit premier moniteur (M1) de commander l'état dudit deuxième aiguilleur (AIG2) si ledit moyen détecteur (DET) n'a pas préalablement détecté qu'au moins un desdits premier aiguilleur (AIG1) et deuxième aiguilleur (AIG2) est dans son état repos (REP), et, dans l'autre cas, empêchant ledit premier moniteur (M1) de commander ledit deuxième aiguilleur (AIG2) ;
- un second moyen de verrouillage (P2), interposé entre la sortie (U) dudit second moniteur (M2) et l'entrée de commande (EC) dudit premier aiguilleur (AIG1), recevant, sur une entrée de commande (EP2), ladite information issue de la sortie (Q) du moyen détecteur (DET) et permettant audit deuxième moniteur (M2) de commander l'état dudit premier aiguilleur (AIG1) si ledit moyen détecteur (DET) n'a pas préalablement détecté qu'au moins un desdits premier aiguilleur (AIG1) et deuxième aiguilleur (AIG2) est dans son état repos (REP), et, dans l'autre cas, empêchant ledit deuxième moniteur (M2) de commander ledit premier aiguilleur (AIG1).

10. Sélecteur de signaux (GS) ayant une pluralité de n entrées (I1 à In) et deux sorties (S1, S2), comportant une pluralité de n-2 sélecteurs (FS1 à FSn-2) de signaux à trois entrées (avec n entier ≥3), selon l'une quelconque des revendications 1 à 9,
caractérisé en ce que lesdits sélecteurs (FS1 à FSn-2) de signaux à trois entrées sont respectivement montés en cascade, les trois entrées (E1, E2, E3) du premier sélecteur (FS1) de signaux à trois entrées étant respectivement reliées à trois (I1, I2, I3) desdites n entrées (I1 à In), alors que, pour chacun des (n-3) autres sélecteurs (FSi) de signaux à trois entrées de rang i (avec 1<i≤n-2), deux de ses entrées (E1, E2) sont reliées respectivement aux sorties (S1, S2) du sélecteur (FSi-1) de signaux à trois entrées amont de rang i-1, la troisième (E3) desdites entrées du sélecteur (FSi) de signaux à trois entrées de rang i étant reliée en propre à l'une desdites n entrées (I1 à In) dudit sélecteur de signaux (GS) à n entrées, tandis que les sorties (S1, S2) du sélecteur (FSn-2) de signaux le plus en aval sont respectivement reliées aux sorties (S1, S2) dudit sélecteur de signaux (GS) à n entrées.

11. Voteur (V) à n entrées (I1, I2, I3, ..., Ii, ..., In), et une sortie (S), comportant un sélecteur de signaux (GS) à n entrées tel que défini dans la revendication 10,
caractérisé en ce qu'il comporte :
- un premier interrupteur (INT1), pourvu d'une entrée active (A) et d'une entrée de commande (EC) apte à mettre, ou non, ladite entrée active (A) en relation avec une sortie commune (SC) selon que ce premier interrupteur (INT1) est respectivement à l'état actif ou à l'état repos, en fonction du signal appliqué sur ladite entrée de commande (EC), ladite entrée active (A) et ladite sortie commune (SC) dudit premier interrupteur (INT1) étant respectivement reliées à l'une desdites sorties (S1, S2) du sélecteur de signaux (GS) à n entrées et à la sortie (S) dudit voteur à n entrées ; et
- un premier moniteur de sortie (MS1), à deux entrées (X,Y), tel que défini dans les revendications 1 à 10, dont les deux entrées (X, Y) sont respectivement reliées auxdites sorties (S1 et S2) du sélecteur de signaux (GS) à n entrées et sont aptes à mesurer l'écart entre les signaux (Sₛ1, Sₛ2) apparaissant sur lesdites sorties (S1, S2) du sélecteur de signaux (GS) à n entrées, et dont la sortie (U) est reliée à l'entrée de commande (EC) dudit premier interrupteur (INT1) et est susceptible de commander l'état dudit premier interrupteur (INT1).

12. Voteur (V) à n entrées selon la revendication 11,
caractérisé en ce qu'il comporte :
- m interrupteurs (INTj) (avec j entier = 1 à m) tels que définis dans la revendication 11, lesdites entrée active (A) et sortie commune (SC) de chacun desdits m interrupteurs (INTj) étant respectivement reliées à l'une desdites sorties (S1, S2) dudit sélecteur de signaux (GS) à n entrées et à la sortie (S) dudit voteur (V) à n entrées ; et
- m moniteurs de sortie (Msj), à deux entrées (Xj, Yj), dont l'une (Xj) des deux entrées est reliée à l'une (S1) des sorties dudit sélecteur de signaux (GS) à n entrées et dont l'autre (Yj) des deux entrées est reliée à l'autre (S2) des sorties dudit sélecteur de signaux (GS) à n entrées, aptes à mesurer l'écart entre les signaux (Sₛ1, Sₛ2) apparaissant sur lesdites sorties (S1, S2) dudit sélecteur de signaux (GS) à n entrées, et dont la sortie (Uj) est reliée en propre à l'entrée de commande (ECj) de l'un desdits m interrupteurs (INTj), de même rang j, et est susceptible de commander l'état dudit interrupteur (INTj).

## Patentansprüche

1. Signalwähler (FS) mit einem ersten Eingang (E1), einem zweiten Eingang (E2) und einem dritten Eingang (E3), an die jeweils ein erstes Signal (Eₛ1), ein zweites Signal (Eₛ2) und ein drittes Signal (Eₛ3) gelangen kann, und mit einem ersten Ausgang (S1) und einem zweiten Ausgang (S2),
dadurch gekennzeichnet, daß er umfaßt:
- eine erste Zweiwegweiche (AIG1) mit einem aktiven Eingang (A), einem Ruheeingang (R) und einem Steuereingang (EC), an den ein Steuersignal gelangen kann, das entsprechend seinem Zustand die erste Weiche (AIG1) in einen aktiven Zustand (ACT) oder in einen Ruhezustand (REP) setzt, und mit einem gemeinsamen Ausgang (SC), wobei der Ruheeingang (R) und der aktive Eingang (A) der ersten Weiche (AIG1) mit dem ersten Eingang (E1) bzw. dem zweiten Eingang (E2) des Signalwählers (FS) verbunden sind, während der gemeinsame Ausgang (SC) der ersten Weiche (AIG1) mit dem ersten Ausgang (S1) des Signalwählers (FS) verbunden ist, wobei dieser gemeinsame Ausgang (SC) das Signal am aktiven Eingang (A) überträgt, wenn sich die erste Weiche (AIG1) im aktiven Zustand (ACT) befindet, und das Signal am Ruheeingang (R) überträgt, wenn sich die erste Weiche (AIG1) im Ruhezustand (REP) befindet;
- eine zweite Zweiwegweiche (AIG2) mit einem aktiven Eingang (A), einem Ruheeingang (R) und einem Steuereingang (EC), an den ein Steuersignal gelangen kann, das entsprechend seinem Zustand die Weiche (AIG2) in einen aktiven Zustand (ACT) oder in einen Ruhezustand (REP) setzt, und mit einem gemeinsamen Ausgang (SC), wobei der aktive Eingang (A) und der Ruheeingang (R) der zweiten Weiche (AIG2) mit dem zweiten Eingang (E2) bzw. mit dem dritten Eingang (E3) des Signalwählers (FS) verbunden sind, während der gemeinsame Ausgang (SC) der zweiten Weiche (AIG2) mit dem zweiten Ausgang (S2) des Signalwählers (FS) verbunden ist, wobei dieser gemeinsame Ausgang (SC) das Signal am aktiven Eingang (A) überträgt, wenn sich die zweite Weiche (AIG2) im aktiven Zustand (ACT) befindet, und das Signal am Ruheeingang (R) überträgt, wenn sich die zweite Weiche (AIG2) im Ruhezustand (REP) befindet;
- einen ersten Monitor (M1) mit zwei Eingängen (X, Y), die mit dem ersten Eingang (Ei) bzw. dem zweiten Eingang (E2) des Signalwählers (FS) verbunden sind, der die Abweichung zwischen dem ersten Signal (ES1) und dem zweiten Signal (ES2) messen kann und dessen Ausgang (U) mit dem Steuereingang (EC) der zweiten Weiche (AIG2) verbunden ist und den Zustand dieser zweiten Weiche (AIG2) steuern kann; und
- einen zweiten Monitor (M2) mit zwei Eingängen (X, Y), die mit dem zweiten Eingang (E2) bzw. dem dritten Eingang (E3) des Signalwählers (FS) verbunden sind, der die Abweichung zwischen dem zweiten Signal (ES2) und dem dritten Signal (ES3) messen kann und dessen Ausgang (U) mit dem Steuereingang (EC) der ersten Weiche (AIG1) verbunden ist und den Zustand dieser ersten Weiche (AIG1) steuern kann,
wobei der Zustand der Ausgänge (U) der Monitore (M1, M2) und der Zustand der Weichen (AIG1, AlG2),wenn das erste, zweit, oder dritte Signal (Es1,Es2,Es3) falsch ist, für die Identität des Eingangs (E1,E2,E3), an dem ein falsches Signal übertragen wird, repräsentativ sind.

2. Signalwähler (FS) nach Anspruch 1, dessen Monitore (M) derart sind, daß sie analoge oder digitale, serielle oder parallele Signale verarbeiten können,
dadurch gekennzeichnet, daß jeder der Monitore (M) umfaßt:
- Differenziermittel (D) zur Messung der Differenz zwischen den an die Eingänge (X, Y) des Monitors (M) angelegten Signalen;
- Komparatoren (C) zum Vergleich der Differenz mit einer vorbestimmten Schwelle (TC+, TC-) und zur Erzeugung eines Fehlersignals, wenn der absolute Wert der Differenz größer als der absolute Wert der Schwelle (TC+, TC-) ist.

3. Signalwähler (FS) nach Anspruch 1 oder 2, dadurch gekennzeichnet, daß Verzögerungsmittel (DT) am Ausgang (U) mindestens eines Monitors (M) in Reihe geschaltet sind.

4. Signalwähler (FS) nach einem der Ansprüche 1 bis 3, dadurch gekennzeichnet, daß jede Zweiwegweiche (AIG) von der Art eines elektrischen Schalters oder einer elektrischen Schaltvorrichtung ist, die aus mehreren parallel angeordneten identischen Schaltelementen besteht.

5. Signalwähler (FS) nach einem der Ansprüche 1 bis 3,
dadurch gekennzeichnet, daß jede Zweiwegweiche (AIG) von der Art eines elektrisch gesteuerten optischen Multiplexers oder eines elektrisch gesteuerten optischen Schalters ist, der aus mehreren parallel angeordneten identischen optischen Schaltelementen besteht.

6. Signalwähler (FS) nach einem der Anspüche 1 bis 3,
dadurch gekennzeichnet, daß jede Zweiwegweiche (AIG) von der Art eines hydraulischen oder pneumatischen Schalters oder eines hydraulischen oder pneumatischen Schalters, der aus mehreren parallel angeordneten identischen Schaltelementen besteht, ist.

7. Signalwähler (FS) nach Anspruch 6, dessen Monitore (M) Druckmittelsignale verarbeiten können,
dadurch gekennzeichnet, daß jeder der Monitore (M) ein Organ (43) hat, das der Gegenwirkung der Signale an den Signaleingängen (X, Y) des Monitors (M) unterliegt und den Druckmitteldurchfluß zwischen einer Druckquelle (30) und dem Ausgang (U) des Monitors (M) steuert.

8. Signalwähler (FS) nach Anspruch 6 oder 7,
dadurch gekennzeichnet, daß jede Weiche (AIG) ein Organ (53) hat, das der Wirkung des Signals am Steuereingang (EC) der Weiche (AIG) unterliegt, wobei das Organ (53) die eine oder die andere von zwei Signaleingangsöffnungen (57,58) mit einer Ausgangsöffnung (54) in Verbindung bringen kann.

9. Signalwähler (FS) nach einem der Ansprüche 1 bis 8,
dadurch gekennzeichnet, daß:
- die erste Weiche (AIG1) und die zweite Weiche (AIG2) jeweils außerdem einen Zustandsausgang (SE) haben, der ein Signal abgibt, das für den aktiven Zustand (ACT) oder den Ruhezustand (REP) der Weiche (AIG1, AIG2) repräsentativ ist;
und dadurch, daß er umfaßt:
- ein Nachweismittel (DET) mit zwei Eingängen (D1,D2), die jeweils mit dem Zustandsausgang (SE) der ersten Weiche (AIG1) und der zweiten Weiche (AIG2) verbunden sind, das an seinem Ausgang (Q) eine Information abgeben kann, die für den Ruhezustand (REP) mindestens der ersten Weiche (AIG1) oder der zweiten Weiche (AIG2) signifikant ist;
- ein erstes Verriegelungsmittel (P1) zwischen dem Ausgang (U) des ersten Monitors (M1) und dem Steuereingang (EC) der zweiten Weiche (AIG2), an dessen Steuereingang (EP1) die Information aus dem Ausgang (Q) des Nachweismittels (DET) gelangt, durch die der erste Monitor (M1) den Zustand der zweiten Weiche (AIG2) steuern kann, wenn das Nachweismittel (DET) nicht zuvor nachgewiesen hat, daß sich mindestens die erste Weiche (AIG1) oder die zweite Weiche (AIG2) im Ruhezustand (REP) befindet, und andernfalls die Steuerung der zweiten Weiche (AIG2) durch den ersten Monitor (M1) verhindert;
- ein zweites Verriegelungsmittel (P2) zwischen dem Ausgang (U) des zweiten Monitors (M2) und dem Steuereingang (EC) der ersten Weiche (AIG1), an dessen Steuereingang (EP2) die Information aus dem Ausgang (Q) des Nachweismittels (DET) gelangt, durch die der zweite Monitor (M2) den Zustand der ersten Weiche (AIG1) steuern kann, wenn das Nachweismittel (DET) nicht zuvor nachgewiesen hat, daß sich mindestens die erste Weiche (AIG1) oder die zweite Weiche (AIG2) im Ruhezustand (REP) befindet, und andernfalls die Steuerung der ersten Weiche (AIG1) durch den zweiten Monitor (M2) verhindert.

10. Signalwähler (GS) mit einer Vielzahl von n Eingängen (I1 bis In) und zwei Ausgängen (S1, S2), bestehend aus einer Vielzahl von n-2 Signalwählern (FS1 bis FSn-2) mit drei Eingängen (mit n ganze Zahl ≥3), nach einem der Ansprüche 1 bis 9,
dadurch gekennzeichnet, daß die Signalwähler (FS1 bis FSn-2) mit drei Eingängen jeweils in Kaskade geschaltet sind, wobei die drei Eingänge (E1, E2, E3) des ersten Signalwählers (FS1) mit drei Eingängen jeweils mit drei (I1, I2, I3) der n Eingänge (I1 bis In) verbunden sind, während bei jedem der (n-3) anderen Signalwähler (FSi) mit drei Eingängen von Rang i (mit 1<i≤n-2) zwei der Eingänge (E1, E2) jeweils mit den Ausgängen (S1, S2) des vorgeschalteten Signalwählers (FSi-1) mit drei Eingängen von Rang i-1 verbunden sind, wobei der dritte (E3) Eingang des Signalwählers (FSi) mit drei Eingängen von Rang i mit einem der n Eingänge (I1 bis In) des Signalwählers (GS) mit n Eingängen verbunden ist, während die Ausgänge (S1, S2) des Signalwählers (FSn-2) am Ende jeweils mit den Ausgängen (S1, S2) des Signalwählers (GS) mit n Eingängen verbunden sind.

11. Auswahlvorrichtung (V) mit n Eingängen (I1, I2, I3, ..., Ii, ..., In) und einem Ausgang (S), mit einem Signalwähler (GS) mit n Eingängen entsprechend Anspruch 10,
dadurch gekennzeichnet, daß sie umfaßt:
- einen ersten Schalter (INT1) mit einem aktiven Eingang (A) und einem Steuereingang (EC), durch den der aktive Eingang (A) mit einem gemeinsamen Ausgang (SC) verbunden werden kann, je nachdem, ob sich dieser erste Schalter (INT1) in Abhängigkeit von dem Signal am Steuereingang (EC) im aktiven Zustand oder im Ruhezustand befindet, wobei der aktive Eingang (A) und der gemeinsame Ausgang (SC) des ersten Schalters (INT1) mit einem der Ausgänge (S1, S2) des Signalwählers (GS) mit n Eingängen bzw. mit dem Ausgang (S) der Auswahlvorrichtung mit n Eingängen verbunden sind; und
- einen ersten Ausgangsmonitor (MS1) mit zwei Eingängen (X,Y) entsprechend Anspruch 1 bis 10, dessen beide Eingänge (X, Y) jeweils mit den Ausgängen (S1 und S2) des Signalwählers (GS) mit n Eingängen verbunden und geeignet sind, die Abweichung zwischen den Signalen (Sₛ1, Sₛ2) an den Ausgängen (S1, S2) des Signalwählers (GS) mit n Eingängen zu messen, und dessen Ausgang (U) mit dem Steuereingang (EC) des ersten Schalters (INT1) verbunden ist und den Zustand des ersten Schalters (INT1) steuern kann.

12. Auswahlvorrichtung (V) mit n Eingängen nach Anspruch 11,
dadurch gekennzeichnet, daß sie umfaßt:
- m Schalter (INTj) (mit j ganze Zahl = 1 bis m) entsprechend Anspruch 11, wobei der aktive Eingang (A) und der gemeinsame Ausgang (SC) jedes der m Schalter (INTj) mit einem der Ausgänge (S1, S2) des Signalwählers (GS) mit n Eingängen bzw. mit dem Ausgang (S) der Auswahlvorrichtung (V) mit n Eingängen verbunden sind; und
- m Ausgangsmonitore (Msj) mit zwei Eingängen (Xj, Yj), bei denen einer (Xj) der beiden Eingänge mit einem (S1) der Ausgänge des Signalwählers (GS) mit n Eingängen verbunden ist und der andere (Yj) der beiden Eingänge mit dem anderen (S2) der Ausgänge des Signalwählers (GS) mit n Eingängen verbunden ist, die die Abweichung zwischen den Signalen (Sₛ1, Sₛ2) an den Ausgängen (S1, S2) des Signalwählers (GS) mit n Eingängen messen können und deren Ausgang (Uj) mit dem Steuereingang (ECj) eines der m Schalter (INTj) von gleichem Rang j verbunden ist und den Zustand des Schalters (INTj) steuern kann.

## Claims

1. Signal selector (FS) comprising a first input (E1), a second input (E2) and a third input (E3) which are able to receive respectively a first signal (Eₛ1), a second signal (Eₛ2) and a third signal (Eₛ3) and comprising a first output (S1) and a second output (S2), characterized in that it comprises:
- a first two-channel diverter (AIG1) provided with an active input (A), with a quiescent input (R), and with a control input (EC) which is able to receive a control signal which sets, depending on its state, the said first diverter (AIG1) to an active state (ACT) or to a quiescent state (REP), and with a common output (SC), the said quiescent input (R) and the said active input (A) of the said first diverter (AIG1) being respectively connected to the said first input (E1) and second input (E2) of the said signal selector (FS), whereas the said common output (SC) of the said first diverter (AIG1) is connected to the said first output (S1) of the signal selector (FS), this common output (SC) transmitting the signal applied to the active input (A) when the said first diverter (AIG1) is in the active state (ACT), and transmitting the signal applied to the quiescent input (R) when the said first diverter (AIG1) is in the quiescent state (REP);
- a second two-channel diverter (AIG2) provided with an active input (A), with a quiescent input (R), and with a control input (EC) which is able to receive a control signal which sets, depending on its state, the said diverter (AIG2) to an active state (ACT) or to a quiescent state (REP), and with a common output (SC), the said active input (A) and the said quiescent input (R) of the said second diverter (AIG2) being respectively connected to the said second input (E2) and third input (E3) of the said signal selector (FS), whereas the said common output (SC) of the said second diverter (AIG2) is connected to the said second output (S2) of the signal selector (FS), this common output (SC) transmitting the signal applied to the active input (A) when the said second diverter (AIG2) is in the active state (ACT), and transmitting the signal applied to the quiescent input (R) when the said second diverter (AIG2) is in the quiescent state (REP);
- a first monitor (M1) with two inputs (X, Y), connected respectively to the said first input (E1) and second input (E2) of the said signal selector (FS), which is able to measure the deviation between the said first signal (Eₛ1) and second signal (Eₛ2) and whose output (U) is connected to the control input (EC) of the said second diverter (AIG2) and is able to control the state of this second diverter (AIG2); and
- a second monitor (M2) with two inputs (X, Y), connected respectively to the said second input (E2) and third input (E3) of the said signal selector (FS), which is able to measure the deviation between the said second signal (Eₛ2) and third signal (Eₛ3) and whose output (U) is connected to the control input (EC) of the said first diverter (AIG1) and is able to control the state of this first diverter (AIG1); the state of the outputs (U) of the said monitors (M1, M2) and the state of the said diverters (AIG1, AIG2 ) being, when one of the said first, second or third signals (Eₛ1, Eₛ2, Eₛ3) is incorrect, representative of the identity of the input (E1, E2, E3) transmitting an incorrect signal.

2. Signal selector (FS) according to Claim 1, in which the said monitors (M) are of the type able to process analog or digital, serial or parallel signals, characterized in that each of the said monitors (M) comprises:
- differentiator means (D) for measuring the difference between the signals applied to the inputs (X, Y) of the said monitor (M);
- comparator means (C) for comparing the said difference with a predetermined threshold (TC⁺, TC⁻) and for generating an error signal if the absolute value of the said difference is greater than the absolute value of the said threshold (TC⁺, TC⁻).

3. Signal selector (FS) according to Claim 1 or 2, characterized in that delay timer means (DT) are interposed in series with the output (U) of at least one monitor (M).

4. Signal selector (FS) according to any one of Claims 1 to 3, characterized in that each two-channel diverter (AIG) is of the electric switch type or electric switching device consisting of several identical switching elements arranged in parallel.

5. Signal selector (FS) according to any one of Claims 1 to 3, characterized in that each two-channel diverter (AIG) is of the optical multiplexer type with electric control or optical switch with electric control consisting of several identical optical switching elements arranged in parallel.

6. Signal selector (FS) according to any one of Claims 1 to 3, characterized in that each two-channel diverter (AIG) is of the hydraulic or pneumatic switch type or hydraulic or pneumatic switch consisting of several identical switching elements arranged in parallel.

7. Signal selector (FS) according to Claim 6, in which the said monitors (M) are able to process fluid pressure signals, characterized in that each of the said monitors (M) comprises a member (43) subject to the opposing action of the signals appearing in the signal inputs (X, Y) of the said monitor (M) and controlling the passage of fluid between a pressure source (30) and the output (U) of the said monitor (M).

8. Signal selector (FS) according to Claim 6 or 7, characterized in that each of the said diverters (AIG) comprises a member (53), subject to the action of the signal applied to the control input (EC) of the said diverter (AIG), the said member (53) being able to place one or the other of two signal input ports (57, 58) in communication with an output port (54).

9. Signal selector (FS) according to any one of Claims 1 to 8, characterized in that:
- the first diverter (AIG1) and second diverter (AIG2) comprise respectively, additionally, a state output (SE) providing a signal representative of the active (ACT) or quiescent (REP) state of the said diverter (AIG1, AIG2);
and in that it comprises:
- a detector means (DET) with two inputs (D1, D2), connected respectively to the state output (SET of the first diverter (AIG1) and of the second diverter (AIG2), which is able to provide, on its output (Q), an item of information indicative of the presence of one at least of the first diverter (AIG1) and second diverter (AIG2) in the quiescent state (REP);
- a first interlock means (P1), interposed between the output (U) of the said first monitor (M1) and the control input (EC) of the said second diverter (AIG2), receiving, on a control input (EP1), the said item of information arising from the output (Q) of the detector means (DET) and enabling the said first monitor (M1) to control the state of the said second diverter (AIG2) if the said detector means (DET) has not previously detected that at least one of the said first diverter (AIG1) and second diverter (AIG2) is in its quiescent state (REP), and, in the other case, preventing the said first monitor (M1) from controlling the said second diverter (AIG2);
- a second interlock means (P2), interposed between the output (U) of the said second monitor (M2) and the control input (EC) of the said first diverter (AIG1), receiving, on a control input (EP2), the said item of information arising from the output (Q) of the detector means (DET) and enabling the said second monitor (M2) to control the state of the said first diverter (AIG1) if the said detector means (DET) has not previously detected that at least one of the said first diverter (AIG1) and second diverter (AIG2) is in its quiescent state (REP), and, in the other case, preventing the said second monitor (M2) from controlling the said first diverter (AIG1).

10. Signal selector (GS) having a plurality of n inputs (I1 to In) and two outputs (S1, S2), comprising a plurality of n-2 signal selectors (FS1 to FSn-2) with three inputs (where n is an integer ≥ 3), according to any one of Claims 1 to 9, characterized in that the said three-input signal selectors (FS1 to FSn-2) are respectively mounted in cascade, the three inputs (E1, E2, E3) of the first three-input signal selector (FS1) being respectively connected to three (I1, I2, I3) of the said n inputs (I1 to In), whereas, for each of the (n-3) other three-input signal selectors (FSi) of rank i (where I<i≤n-2), two of its inputs (E1, E2) are connected respectively to the outputs (S1, S2) of the upstream three-input signal selector (FSi-1) of rank i-1, the third (E3) of the said inputs of the three-input signal selector (FSi) of rank i being connected inherently to one of the said n inputs (I1 to In) of the said signal selector (GS) with n inputs, whereas the outputs (S1, S2) of that signal selector (FSn-2) which is furthest downstream are connected respectively to the outputs (S1, S2) of the said signal selector (GS) with n inputs.

11. Poller (V) with n inputs (I1, I2, I3 ..., Ii, ..., In) and one output (S), comprising a signal selector (GS) with n inputs, as defined in Claim 10, characterized in that it comprises:
- a first interrupter (INT1) provided with an active input (A) and with a control input (EC) which is able to place, or not, the said active input (A) in connection with a common output (SC), depending on whether this first interrupter (INT1) is respectively in the active state or in the quiescent state, as a function of the signal applied to the said control input (EC), the said active input (A) and the said common output (SC) of the said first interrupter (INT1) being respectively connected to one of the said outputs (S1, S2) of the signal selector (GS) with n inputs and to the output (S) of the said poller with n inputs; and
- a first output monitor (MS1), with two inputs (X,Y), as defined in Claims 1 to 10, whose two inputs (X, Y) are respectively connected to the said outputs (S1 and S2) of the signal selector (GS) with n inputs and are able to measure the deviation between the signals (Sₛ1, Sₛ2) appearing on the said outputs (S1, S2) of the signal selector (GS) with n inputs, and whose output (U) is connected to the control input (EC) of the said first interrupter (INT1) and is able to control the state of the said first interrupter (INT1).

12. Poller (V) with n inputs according to Claim 11, characterized in that it comprises:
- m interrupters (INTj) (where j is an integer = 1 to m) as defined in Claim 11, the said active input (A) and common output (SC) of each of the said m interrupters (INTj) being connected respectively to one of the said outputs (S1, S2) of the said signal selector (GS) with n inputs and to the output (S) of the said poller (V) with n inputs; and
- m output monitors (Msj) with two inputs (Xj, Yj), one (Xj) of the two inputs of which is connected to one (S1) of the outputs of the said signal selector (GS) with n inputs and the other (Yj) of the two inputs of which is connected to the other (S2) of the outputs of the said signal selector (GS) with n inputs, which are able to measure the deviation between the signals (Sₛ1, Sₛ2) appearing on the said outputs (S1, S2) of the said signal selector (GS) with n inputs, and whose output (Uj) is connected inherently to the control input (Ecj) of one of the said m interrupters (INTj), of like rank j, and is able to control the state of the said interrupter (INTj).
